(19) Europäisches Patentamt

European Patent Office

Office européen des brevets

(11) EP 1 068 666 B1

(12) EUROPEAN PATENT SPECIFICATION

(45) Date of publication and mention
of the grant of the patent:
28.05.2003 Bulletin 2003/22

(51) Int Cl.⁷: H03F 3/217, H03F 1/32

(21) Application number: 99911417.6

(86) International application number:
PCT/US99/05681

(22) Date of filing: 16.03.1999

(87) International publication number:
WO 99/052206 (14.10.1999 Gazette 1999/41)

(54) **HYBRID CHIREIX/DOHERTY AMPLIFIERS POWER WAVEFORM SYNTHESIS**

CHIREIX/DOHERTY HYBRIDVERSTÄRKER FÜR LEISTUNGSWELLENFORMSYNTHESE

SYNTHESE DE LA FORME D'ONDE DE PUISSANCE D'AMPLIFICATEURS CHIREIX/DOHERTY HYBRIDES

(84) Designated Contracting States:
BE DE ES FI FR GB IT SE

(30) Priority: 02.04.1998 US 54063
02.04.1998 US 54060
10.12.1998 US 209104

(43) Date of publication of application:
17.01.2001 Bulletin 2001/03

(73) Proprietor: Ericsson, Inc.
Research Triangle Park, NC 27709-3969 (US)

(72) Inventor: DENT, Paul, Wilkinson
Pittsboro, NC 27312 (US)

(74) Representative: Vigars, Christopher Ian
Haseltine Lake & Co.,
Imperial House,
15-19 Kingsway
London WC2B 6UD (GB)

(56) References cited:
EP-A- 0 471 346          EP-A- 0 725 478
GB-A- 2 267 402          US-A- 3 777 275
US-A- 3 805 139          US-A- 3 906 401
US-A- 3 909 742          US-A- 3 927 379
US-A- 4 090 147          US-A- 4 178 557
US-A- 4 420 723          US-A- 4 433 312
US-A- 4 485 357          US-A- 4 580 111
US-A- 5 453 717          US-A- 5 734 565

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

**Field of the Invention**

This invention relates to power amplifiers and amplifying methods, and more particularly to high-efficiency power amplifiers and related methods

**Background of the Invention**

Power amplifiers are widely used in communication systems, for example in radiotelephone base stations and radiotelephones. In radiotelephone communication systems, power amplifiers typically amplify high frequency signals for transmission.

A major consideration in the design of power amplifiers is the efficiency thereof. High efficiency is generally desirable so as to reduce the amount of power that is dissipated as heat. Moreover, in many applications, such as in satellites and portable radiotelephones, the amount of power that is available may be limited. An increase in efficiency in the power amplifier is therefore important, in order to allow an increase the operational time or capacity for the satellite or portable radiotelephone.

A conventional power amplifier such as a class-B amplifier generally only provides maximum efficiency at or near to its maximum saturated power output level. In order to accurately reproduce a signal of varying amplitude, the peak output signal level should be equal to or less than that maximum saturated power level. When the instantaneous signal output level is less than the peak, a conventional class-B power amplifier generally operates at less than maximum efficiency.

The efficiency generally reduces as the square root of the output power. This is because, using the class-B example, the output power reduces as the square of the output current but the power consumption from the battery or other DC supply reduces only proportional to the output current. Therefore, the efficiency, which is the ratio of output power to battery power, reduces proportional to the current, i.e., proportional to the square root of the output power.

Accordingly, a power amplifier that has 60% efficiency at a peak output of 2 watts will generally have no more than 42% efficiency at an output of 1 watt (3dB reduced output). Moreover, when amplifying a signal of varying amplitude, a conventional amplifier may not produce an output signal amplitude proportional to the input signal amplitude, thereby causing nonlinear distortion and intermodulation.

With a varying output signal power $P(t) = A^2(t)$, the average efficiency can be estimated to be:

$$\text{Max efficiency} \times \frac{\text{average of } (P(t)/Pmax)}{\text{average of square root } (P(t)/Pmax)}$$

or

$$\text{Max efficiency} \times \frac{\text{average of } (A(t)/Amax)^2}{\text{average of } (A(t)/Amax)}.$$

Nonlinearities in conventional amplifiers can be reduced by various techniques, such as by an inverse predistortion of the input signal, or by feedback including Cartesian feedback in radio frequency power amplifiers for linearly amplifying signals with a bandwidth much less than the center frequency. Unfortunately, linearization generally does not alter the above efficiency formula, which in fact already assumes that the output amplitude can be made to faithfully follow the desired varying amplitude waveform. In effect, the average efficiency calculated above already assumes perfect linearization.

The loss of efficiency comes about because current I(t) is drawn from the battery at a constant voltage Vcc, but is supplied to the load at a varying voltage I(t)·RL which is less than Vcc. The voltage difference Vcc-I(t)·RL is lost across the output device (e.g. collector junction), causing power dissipation in the device.

In U.S. Patent No. 2,210,028 to Doherty (August 1940), an arrangement of two vacuum tube power amplifiers coupled by a single quarter-wave line is described. The first amplifier is operated up to an output level of Pmax/4, at which it achieves maximum practical class-B efficiency. For powers above this level, the second amplifier is caused to contribute. The second amplifier affects the load impedance of the first amplifier one quarter wave away such that the first amplifier can increase its power up to Pmax/2, while the second amplifier also contributes up to Pmax/2, making Pmax in total, at which point both amplifiers are once more achieving maximum practical class-B efficiency. Thus, efficiency is preserved over a 6dB range of output levels from Pmax/4 to Pmax. A semiconductor version of the Doherty amplifier is described in a more recent U.S. patent no. 5,420,541 entitled 'Microwave Doherty amplifier" to Upton et al.

In the prior art Doherty amplifier, the "normal" power amplifier amplifies a signal from 0 power to 1/4 the peak power level, achieving maximum class-B efficiency at that power level. The peak power amplifier then begins to contribute to the output power and by reducing the effective load impedance seen by the "normal" power amplifier, enables it to generate a greater power output up to half the peak power level. The peak power amplifier also generates half the peak power level so that the two amplifiers jointly produce the desired peak power level. The "peak" power amplifier in this prior art is not operated in antiphase so as to detract from the output power level, and thereby increasing the effective load impedance seen by the "normal" power amplifier and allowing it to generate less power efficiently. Thus the "peak" power amplifier does not operate symmetrically as a "trough" power amplifier.

In Proc. IRE, Vol. 23 No. 11 (1935), pages 1370-1392, entitled *"High Power Outphasing Modulation ",* Chireix describes producing a transmitter giving a modulated amplitude output signal by combining two constant output amplitude amplifiers with a variable phase difference so that their outputs can be varied in relative phase from additive to subtractive. The Chireix and Doherty techniques were not combined to obtain an amplifier of good linearity and high efficiency, as the Doherty amplifier relied on the two constituent amplifiers being co-phased while the Chireix amplifier relied upon them being out-of-phase. When two amplifiers are out-of-phase, they were in the prior art, preferably isolated from one another using a hybrid coupler or directional coupler to combine them. The directional coupler combines the two amplifier's output signals to produce a sum signal and a difference signal, the sum signal being used as the desired output and the difference signal being terminated in a dummy load. Since all the amplifier power ends up at either the sum or the difference port and is not reflected to either amplifier, the amplifiers are isolated from one another and do not affect each other's load line.

In U.S. Patents No.'s 5,568,088, 5, 574, 967, 5,631,604, and 5,638,024 to applicant Dent, all entitled *"Waste Energy Control and Management in Power Amplifiers*", various arrangements of coupled power amplifiers are disclosed in which a varying amplitude signal may be produced using constant amplitude power amplifiers. In one arrangement, two constant power amplifiers are driven with a relative phase shift as in Chireix such that their outputs add more or less constructively or destructively to produce a varying output The amplifiers were coupled at their outputs using a hybrid coupler or directional coupler which forms both a sum signal and a difference signal. An improvement over the prior art described therein comprises recovering the normally wasted energy at the difference port using a rectifier circuit.

In applicant's 1964 graduate thesis project, an amplifier was built and reported in which the value of Vcc was selected to be either Vcc or 0.7 Vcc based on whether the desired output amplitude was greater or less than 0.7 Vcc. With a pure sine wave drive, this raised the peak efficiency from the theoretical value of $\pi/4$ ($\sim$78.5%) for a class-B amplifier to 85.6% for the new amplifier, termed class-BC. The efficiency at half maximum output power was now 78.5% instead of 55% for class-B.

The Vcc selection was effected by using a first pair of transistors connected to the 0.7 Vcc supply to supply load current when the output amplitude was less than 0.7 Vcc, and a second pair of transistors connected to the full Vcc supply for supplying the load current for amplitudes between 0.7 Vcc and Vcc. Diodes were used to protect the first pair of transistors by preventing reverse current flow when the output amplitude was driven above their supply voltage. The above arrangement worked well for audio frequencies where diodes turn on and off sufficiently fast, but may not be effective for microwave frequencies.

Also in the 1960's, many so called "class-D" or pulse-width modulation amplifiers were proposed and manufactured. Pulse-width modulation amplifiers switched the output devices on and off at a high frequency with a mark-space ratio proportional to the instantaneous desired signal waveform. A low-pass output filter smoothed the switching signal to reject the high switching frequency and to produce the mean of the varying mark-space ratio signal as the desired output signal waveform. A disadvantage of the class-D amplifier was the need to switch the output devices at a very much higher frequency than the desired signal to be amplified, which may not be practical when the desired signal is already a high frequency signal such as a microwave signal.

The above survey indicates that many techniques have been used in order to improve the efficiency of power amplifiers. However, notwithstanding these techniques, there continues to be a need for power amplifiers that can operate at high efficiencies at maximum output, and also at outputs that are below maximum output. Moreover, it is desirable for high efficiency power amplifiers to operate with high frequency signals, such as are used in wireless communication systems.

Conventional DC-to-AC power converters include square wave inverters, modified sinewave inverters and true sinewave inverters. Square wave inverters convert DC-to-AC power, but their square-wave output signal waveform may contain large amounts of odd harmonic energy. Certain electronic devices do not operate efficiently when large harmonic content is present in the output waveform. For example, radio or audio interference may occur when attempting to power a radio or TV set from such an inverter. An additional problem with square wave inverters is that the peak and rms values of the waveform generally do not have the same ratio of $\sqrt{2}$ as in a conventional sinewave supply. Certain loads, such as lamps, only require that the RMS value of a power source should be correct. However, other loads including transformer-rectifier arrangements, may operate correctly only if the peak voltage level is correct. Therefore, all loads may not operate correctly from a square waveform.

The above problems may be partly overcome by using a modified sinewave inverter. A modified sinewave inverter is generally a modified square wave inverter, modified to produce a 3-level output waveform of levels +Vpeak, 0, -Vpeak, 0...in repetitive sequence. Introduction of the 0-level for a properly chosen proportion of the time allows the waveform to have the same peak-to-rms ratio as a sinewave, thus extending the range of apparatus designed for sinewave operation that can be correctly powered by the inverter. However, the odd harmonic content of the waveform may increase in this case, and loads such as motors that are less efficient when large harmonic content is present may still not function efficiently. Thus, there was still a need in the prior art for "true sinewave" inverters.

A true sinewave inverter can be made using a class-B linear amplifier to amplify a sinewave signal to a high power level. However, such an amplifier may achieve a maximum DC-to-AC power conversion efficiency of π/4 or 78.5% even using ideal components. Another prior art means to produce a true sinewave inverter comprises using square-wave switching devices in conjunction with inductor-capacitor filtering to remove harmonics, thereby converting the square switching waveform to a sinusoidal output waveform. However, inverters based on filtering may require very large filtering components and may suffer from poor voltage regulation when loaded by different amounts.

Other prior art true sinewave inverters have been reported in which several square-wave inverters operating at, for example the line frequency, 3 x the line frequency, 5 x the line frequency, etc. have their outputs combined such that the odd harmonic content cancels. Such converters can achieve high efficiency but may be limited in the accuracy of the waveform. They are also generally adapted to convert DC-to-AC power only for a particular waveform, and not for a general waveform such as an audio or radio signal.

It is also known to use a digital-to-analog (D/A) converter as a waveform synthesizer, where the input waveform is a digital waveform. A well known type of D/A converter is a weighted-resistor D/A converter. The weighted resistor D/A converter uses resistor values that are weighted, so that their resistances are inversely proportional to the numerical significance of the corresponding binary digit. The resistors are coupled to a load by a corresponding plurality of switches. The switches may be field effect transistors or complementary bipolar transistors. See pages 494-516 of *"Digital Integrated Electronics"* by Taub and Schilling, 1977.

Notwithstanding all of the above approaches, there continues to be a need for waveform synthesizers that can synthesize waveforms at high efficiency.

EP-A-0471346 discloses a high frequency power amplifier in which the input signal is transformed into two constant envelope signals where the amplitudes of the envelopes are equal and constant. The envelope signals are amplified and the amplified signals are passed through strip lines and summed at the connection point of the strip lines such that the current which flows through the circuit varies depending on the output power.

US-A-4485357 discloses amplitude and phase modulation of a carrier signal by two input signals. The input signals are modulated to generate two different phase-modulated signals having the same carrier and the same amplitude and the phase-modulated signals being summed at the output to produce the amplitude and phase-modulated carrier.

US-A-4580111 discloses an amplitude modulator which generates amplitude modulated carrier signal by selectively combining varying numbers of carrier signals.

### Summary of the Invention

It is therefore an object of the invention to provide improved power amplifiers and amplifying methods.

It is another object of the present invention to provide power amplifiers and amplifying methods that are capable of high efficiency.

It is yet another objection of the present invention to provide power amplifiers and amplifying methods that are capable of high efficiency at high frequencies.

It is still another object of the present invention to provide power amplifiers and amplifying methods that are capable of high efficiencies at levels below their maximum power output.

These and other objects are provided, according to the present invention as defined in Claim 1 and in Claim 3, by coupling two amplifiers that are driven using Chireix out phasing modulation to one another, so that the amplifiers affect each other's effective load line. The two amplifiers can thereby maintain efficiency over a wider dynamic range than in a conventional Doherty amplifier.

More specifically, the invention provides a method for generating from a signal of varying amplitude and varying phase, a plurality of constant amplitude varying phase signals, the sum of which is the signal of varying amplitude and varying phase, the method comprising the steps of: generating a cosine carrier modulation waveform I(t) and a sine carrier modulation waveform Q(t) from the signal of varying amplitude and varying phase; generating a complimentary waveform Q'(t) from the cosine carrier modulation waveform I(t) such that the sum of squares of I(t) and Q'(t) is constant; modulating a cosine carrier signal with I(t) to obtain a first modulated cosine; modulating a sine carrier signal with Q'(t) to obtain a first modulated sine carrier; and forming a sum and difference of the first modulated cosine carrier and the first modulated sine carrier to obtain the constant amplitude varying phase signals.

In one embodiment, the method further comprises generating a complimentary waveform I' (t) from the sine carrier modulation waveform Q(t) such that the sum of squares of I'(t) and Q(t) is constant; modulating a cosine carrier signal with I'(t) to obtain a second modulated cosine carrier; modulating a sine carrier signal with Q(t) to obtain a second modulated sine carrier; and forming a sum and difference of the second modulated cosine carrier and the second modulated sine carrier to obtain a second set of constant amplitude varying phase signals.

According to another aspect of the invention, a system for generating from a signal of varying amplitude and varying phase, a plurality of constant amplitude varying phase signals, the sum of which is the signal of varying amplitude and varying phase, the system comprising means for generating a cosine carrier modulation waveform I(t) and a sine carrier modulation waveform Q(t) from the signal of varying amplitude and varying phase; means for generating a complementary waveform Q'(t) from the cosine carrier modulation waveform I(t) such that the sum of the squares of I (t) and Q'(t) is constant; means for modulating a cosine carrier signal with I(t) to obtain a first modulated cosine carrier; means for modulating a sine carrier signal with Q'(t) to obtain a first modulated sine carrier; and means for forming a sum and difference of the first modulated cosine carrier and the first modulated sine carrier to obtain the constant amplitude varying phase signals.

In one embodiment, the system further comprises means for generating a complementary waveform I'(t) from the sine carrier modulation waveform Q(t) such that the sum of the squares of I'(t) and Q(t) are constant; means for modulating a cosine carrier signal with I'(t) to obtain a second modulated cosine carrier; means for modulating a sine carrier signal with Q(t) to obtain a second modulated sine carrier and means for forming a sum and difference of the second modulated cosine carrier and the second modulated sine carrier to obtain a second set of constant amplitude varying phase signals.

Accordingly, the present invention combines more than two constant amplitude, varying phase vectors to obtain a given resultant vector, the combined vectors being of more slowly varying phase. In one aspect, four constant amplitude power vectors are combined. A first pair of signal vectors is generated, amplified and combined to produce a constant phase, varying amplitude vector, representing the real part of the desired resultant. A second pair of signal vectors is generated, amplified and combined to produce a second, constant phase, varying amplitude vector representing the desired imaginary part of the resultant, ie. a vector at right angles to the real part. Each of the four constant amplitude vectors therefore may be limited in the rate of its required phase variation, allowing the use of lower phase locked loop bandwidths.

A preferred implementation uses a first quadrature modulator comprising a cosine and a sine or I and Q modulator to generate an amplitude modulated cosine carrier signal and an amplitude modulated sinewave carrier signal. The modulated cosine and sine signals are then both added and subtracted to generate two counter-rotating, constant-amplitude vectors whose resultant sum is a cosine signal of amplitude equal to a desired real part. The desired real part is the I-modulation applied to the cosine modulator. The Q-modulation is the square root of $(1-I^2)$, which ensures constant amplitude for both I+jQ and I-jQ. A second quadrature modulator modulates a sine carrier with the desired imaginary or Q part of the desired resultant signal while modulating a cosine carrier with the square root of $(1-Q^2)$, thus ensuring that, after forming jQ+1 and jQ-1, they are both counter-rotating constant amplitude vectors the sum of which is the desired imaginary part. The four constant-amplitude vectors are then power-amplified, for example by using four phase locked loops to transfer the four varying phases to the output of respective power amplifiers at a desired final frequency for transmission.

Any number of constant-amplitude, varying-phase vectors greater than two, for example three, may be generated in such a way that their resultant sum is a desired varying amplitude, varying phase vector. The desired varying amplitude, varying phase vector has two components specified, being the real and the imaginary part respectively. However, the combination of more than two constant amplitude vectors provides excess degrees of freedom, which may be used according to the invention to choose a solution which can reduce and preferably minimize the maximum rate of change of phase of any vector. This solution may be computed by digital signal processing, either in real time, or alternatively, for digital modulations, can be computed off-line for various combinations of successive modulation symbols and stored in a look-up table for use later in generating signals in real time. Amplification systems and methods may be provided.

## Brief Description of the Drawings

Figure 1 graphically illustrates vector addition of two constant envelope signals.

Figure 2 is a block diagram of a conventional power amplifier using quadrature modulators and a pair of isolated power amplifiers.

Figure 3 is a block diagram of a first arrangement of power amplifiers.

Figure 4 is a block diagram of a second arrangement of power amplifiers.

Figure 5 is a block diagram of a third arrangement of power amplifiers.

Figure 6 is a circuit diagram of current and voltage relations in a power. amplifier that uses bilateral devices.

Figure 7 is a block diagram of a fourth arrangement of power amplifiers.

Figure 8 is a block diagram of a fifth arrangement of power amplifiers.

Figure 9 graphically illustrates synthesis of a complex vector using four constant magnitude vectors according to the present invention.

Figure 10 is a block diagram of systems and methods for defining an input signal of varying amplitude and varying phase to a desired power level using more than two signals of constant amplitude and controlled phase according to the present invention.

Figure 11 is a block diagram of a four-phasor modulator of Figure 10.

Figure 12 is a block diagram of systems and methods for filtering a phase modulated signal using phase locked loops according to the present invention.

Figure 13 is a block diagram of another embodiment of systems and methods for defining an input signal of varying amplitude and varying phase to a desired power level using more than two signals of constant amplitude and controlled phase according to the present invention.

Figures 14a and 14b are circuit diagrams of bilateral devices that can be used with the present invention.

Figure 15 is a circuit diagram of waveform synthesis by series connection of bit weighted, square wave inverters according to the invention.

Figure 16 graphically illustrates synthesis of a sinewave using 8-bit waveforms.

Figure 17 is a schematic of a ternary synthesis stage according to the present invention.

Figure 18 is a circuit diagram of waveform synthesis using a square wave inverter for the most significant bit and a linear amplifier for the remaining bits, according to the invention.

## Detailed Description of Preferred Embodiments

The present invention now will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. Like numbers refer to like elements throughout. Moreover, each embodiment described and illustrated herein includes its complementary conductivity type embodiment as well.

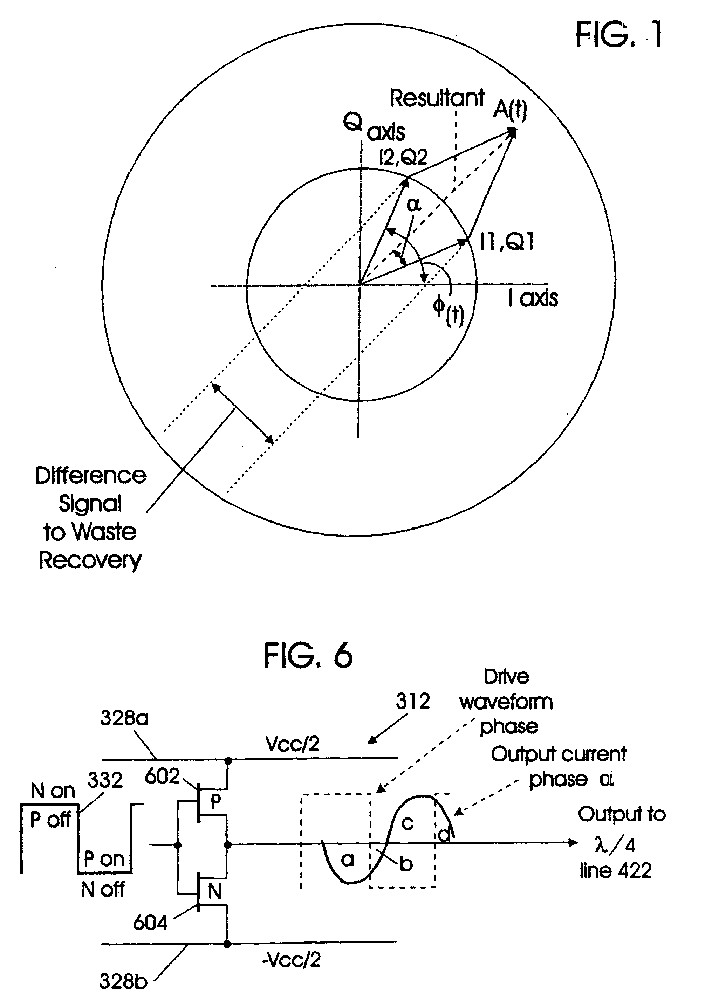

Figure 1 shows how a varying amplitude vector can be constructed by adding two constant amplitude vectors with correct relative phasing, as first proposed by Chireix in his 1935 paper. The inner circle indicates maximum amplitude for one power amplifier, and the outer circle indicates maximum amplitude for two equal power amplifiers. As shown, the desired amplitude is A(t) and the desired phase is $\phi$(t). This may be obtained using first in-phase and quadrature signals I1 and Q1 and second in-phase and quadrature signals I2 and Q2, where I1=COS($\phi$-$\alpha$), Q1=SIN ($\phi$-$\alpha$), I2=COS($\phi$+$\alpha$), and Q2=($\phi$+$\alpha$), where $\alpha$=arcos(A/2).

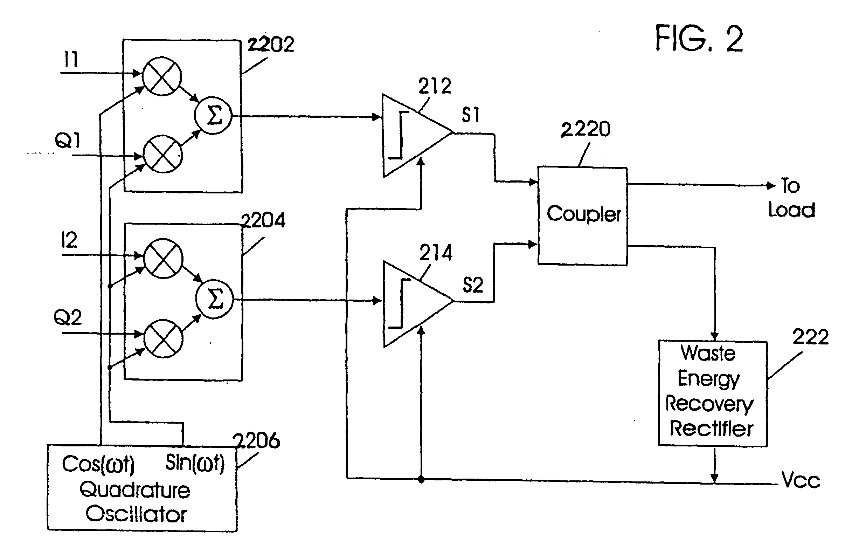

In that era, Chireix did not have the benefit of modem digital signal processing technology to accurately generate the two out-phased signals. A modern implementation using two quadrature modulators 2202, 2204 driven by digitally synthesized vector waveforms I1, Q1, I2, Q2 and a quadrature oscillator 206 is shown in Figure 2.

The output of the two power amplifiers 212, 214 each being for example, a class-C amplifier of power Pmax/2, can be added using a hybrid or -3dB directional coupler 2202 (coupling factor "k" = 0.7071). A hybrid or directional coupler 2220 effectively produces a sum and difference signal. Terminating the difference port and the sum port with like impedances gives isolation between the two power amplifiers so that power (voltage or current) from one does not reach the other. The sum signal rises to Pmax when both amplifiers are driven in phase, and falls to zero when they are driven 180 degrees out of phase. In between, the power is Pmax·cos$^2$($\alpha$) where the '$\alpha$' is the relative phasing. The difference output is Pmax·sin$^2$($\alpha$) and the sum of the outputs is thus always Pmax.

When the desired output P(t) is less than Pmax, the difference Pmax-P(t) comes out the difference port and is normally lost. The average efficiency in this case may be even worse than that calculated above for class-B, as the battery current does not reduce when the output is less than Pmax. On the other hand, there is a possibility that constant envelope amplifiers can be constructed in practice with higher efficiency (at Pmax) than amplifiers with a linearity requirement, so that in practice an advantage may be obtained. However, even if a class-C efficiency of 100% could be obtained, the arrangement would only give 50% efficiency with a peak-to-mean power ratio of 3dB, and 25% with a peak-to-mean ratio of 6dB.

In the Dent patents, U.S. Patents No.'s 5,568,088, 5, 574, 967, 5,631,604, and 5,638,024, to help the efficiency the energy normally dissipated at the difference port of the output coupler is recovered. A waste energy recovery rectifier 222 is used to rectify the dissipated energy and feed the DC current back to the battery. It is known that very efficient rectifiers can be made even at microwave frequencies, as research on wireless power transmission using microwaves has demonstrated.

For digital modulation signals, it is known that the number of different I and Q waveforms that are needed over a data bit interval can be limited to two to the power of a small number of bits surrounding the current bit, because data bits further removed from a current data bit have negligible effect. Thus the waveforms I1, Q1, I2 and Q2 may be precomputed for all two to the power N combinations of nearby bits and stored in memory, and recalled when needed. In that way, the need to compute arc-cosines in real time may be avoided.

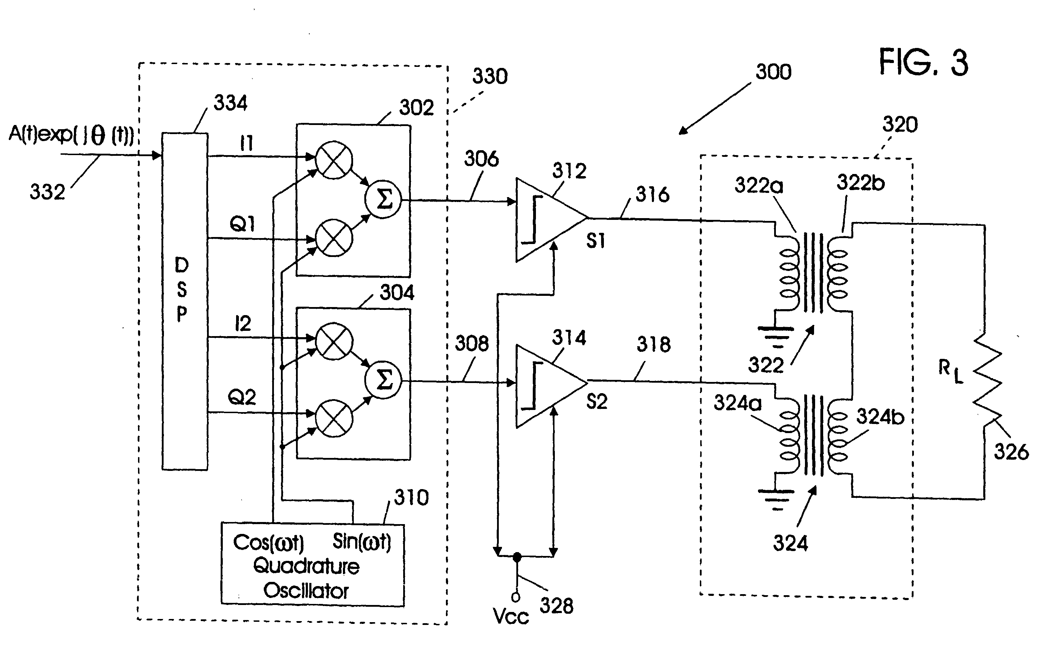

Referring now to Figure 3, a power amplifier **300** is described. Power amplifier **300** amplifies an AC input signal **332** of varying amplitude and varying phase to produce an amplified output signal voltage and an output current in a load impedance $R_L$ **326** using a DC power supply VCC **328**. It will be understood that the load impedance **326** may be an antenna and the DC power supply **328** may be a battery.

Still referring to Figure 3, the power amplifier **300** includes converting means **330** for converting the AC input signal **332** into a first signal **306** having constant amplitude and a first phase angle and into a second signal **308** having constant amplitude and a second phase angle. Converting means **330** may be formed by a digital signal processor (DSP) **334** that generates I1, Q1, I2 and Q2 signals. First and second quadrature modulators **302, 304** respectively, are responsive to a quadrature oscillator **310** and to the in-phase and quadrature signals I1, Q1, I2, Q2 to produce the first signal **306** and second signal **308.** The design and operation of converting means **330,** and the individual components thereof, are well known to those having skill in the art and need not be described further herein.

Still referring to Figure 3, a first amplifier **312** amplifies the first signal **306**, to produce a first output signal voltage **S1 (316)** of constant voltage amplitude. As will be described in detail below, the first amplifier **312** preferably includes bilateral amplifier devices that draw current from the DC power supply, but that also supply current to the DC power supply. Accordingly, the connection between first amplifier **312** and DC power supply **328** is shown to be bidirectional.

Still referring to Figure 3, a second amplifier **314** amplifies the second signal **308** to produce a second output signal voltage of constant voltage amplitude **S2** (**318**). As was described above, the second amplifier **314** also preferably includes bilateral amplifier devices that draw current from the DC power supply and supply current to the DC power supply. Amplifiers **312** and **314** may be class-C power amplifiers, although other classes of power amplifiers may also be used.

Still referring to Figure 3, a coupler **320** couples the first and second amplifiers **312** and **314** to each other and to the load impedance **326** such that the voltage or current in the first amplifier become linearly related to the voltage or current in the second amplifier. Coupler **320** may be contrasted from a directional coupler that was used in a conventional Chireix circuit. In particular, the coupler **320** does not isolate the first and second amplifiers from one another. Rather, it interactively couples the first and second amplifiers to one another, so that each affects the other's load line.

In Figure 3, the coupler **320** comprises a first transformer **322** and a second transformer **324.** Their respective secondaries **322b** and **324b** are serially coupled across a load impedance **326.** Their respective primaries **322a** and **324a** are coupled to the outputs **316** and **318** of first and second amplifiers **312** and **314** respectively. Accordingly, the sum of the first and second output signal voltages **S1** and **S2** produces the amplified output signal voltage across the load impedance **326** and also produces the output current through the load impedance. An amplifier current that is linearly related to the output current flows in the bilateral amplifier devices of both the first and second amplifiers **312** and **314.**

The transformers **322** and **324** facilitate the series coupling of outputs that are relative to ground. The series coupling can ensure that the same current, equal to the load current or a scaled value thereof, flows in the output circuits of both amplifiers **312** and **314.**

By omitting the output coupler of Figure 2, which isolated the two amplifiers from each other, the amplifiers are now allowed to affect or interact with each other. In particular, when the two amplifiers are driven out of phase so that output signal **S1** equals **-S2,** the sum of their outputs into load impedance **RL** will be zero and there will be no load current. Therefore, the current flowing in the amplifier devices will also be zero due to the series connection, which ensures that both amplifier currents and the load current are the same. If no current flows in the amplifier devices, the current consumed from the DC supply voltage Vcc will also be zero. Thus in contrast to the coupled power amplifiers of Figure 2, which consume a constant amount of power from the supply even when the instantaneous load power is zero, the arrangement of Figure 3 can reduce its current consumption as the instantaneous output power is reduced.

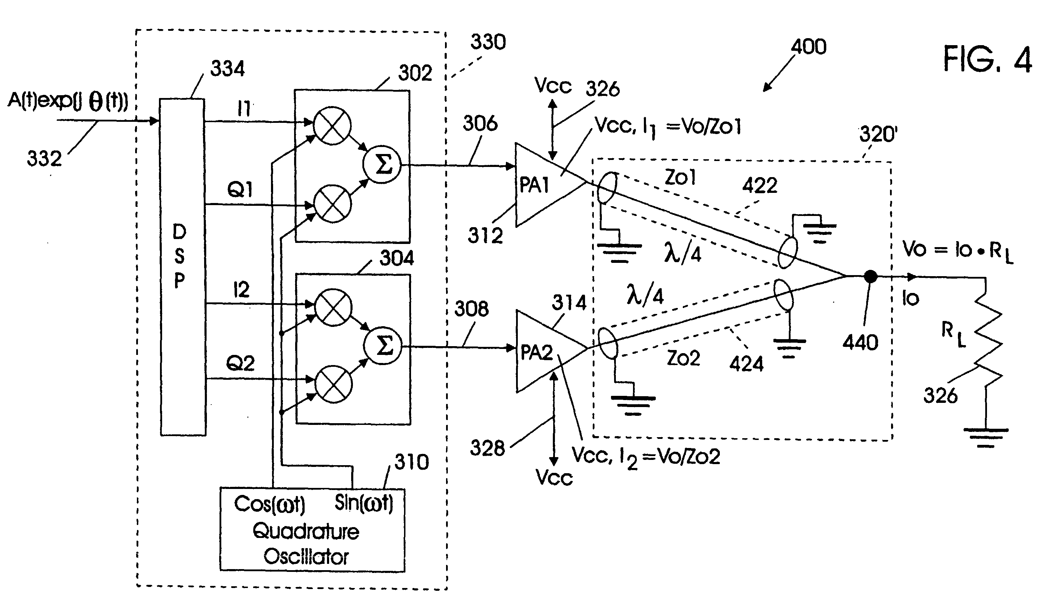

Referring now to Figure 4, a second arrangement of power amplifiers is shown. As shown in Figure 4, power amplifier **400** is similar to power amplifier **300** of Figure 3. However, the interactive coupler **320'** that couples the first and second amplifiers **312** and **314** to the load impedance **326** is embodied by first and second quarter wavelength transmission lines **422** and **424** respectively. The load impedance includes an input node **440**, and the first and second quarter wavelength transmission lines **422** and **424** are preferably coupled to the input node **440**.

As illustrated in Figure 4, series connection at microwave frequencies may be more practically achieved by parallel connection a quarter wave distant, using the two quarter wave lines **422** and **424**. When the outputs of the two quarter wave lines are paralleled, the output voltages are forced to be the same (Vo) at the input node **440.** This forces the currents to be the same quarter-wave away at the power amplifiers **312** and **314,** if the lines are of equal impedance, creating the same conditions as in the series connection of Figure 3. If the transmission lines are of different impedance Zo1, Zo2, the power amplifier output currents I1 and I2 are forced to be scaled in the inverse ratio of the impedances.

The power amplifiers ideally each generate an output swing of Vcc at their ends of their quarter wave lines. Since the voltages are the same at that end, the currents at the other end one quarter wave away must be equal with equal lines. With unequal line impedances, the currents will be respectively Vcc/Zo1 and Vcc/Zo2 at the junction of the lines. The total output current is thus Io = Vcc (1/Zo1 + 1/Zo2) or 2Vcc/Zo for equal lines.

If the power amplifiers generate relatively phased currents Vcc·EXP(j$\alpha$) and Vcc·EXP(-j$\alpha$), then the total output current is:

$$Io = VCC\left(\frac{(EXP(j\alpha)}{Zo} + \frac{EXP(-j\alpha)}{Zo}\right)$$
$$= 2Vcc \cdot Cos(\alpha)/Zo,$$

assuming equal impedance Zo lines.

The voltage Vo is thus given by:

$$Io \cdot R_L = \frac{2VCC \cdot R_L Cos(\alpha)}{Zo}$$

This in turn forces the power amplifier currents to be:

$$\frac{2Vcc \cdot R_L Cos(\alpha)}{Zo^2}$$

showing that the peak current in each power amplifier has reduced by Cos($\alpha$), which it did not do in the case of hybrid coupling. When $\alpha$=90 degrees, the power amplifiers are antiphased, the output signals Vo, Io are zero, but so is the power amplifier current even though they are still driven to full Vcc output swing. It is as if the load impedance had been increased to infinity. Thus, by modulating $\alpha$ (in the DSP code), the effective load impedance seen by the power amplifiers is also modulated so that they generate only the instantaneously desired output power

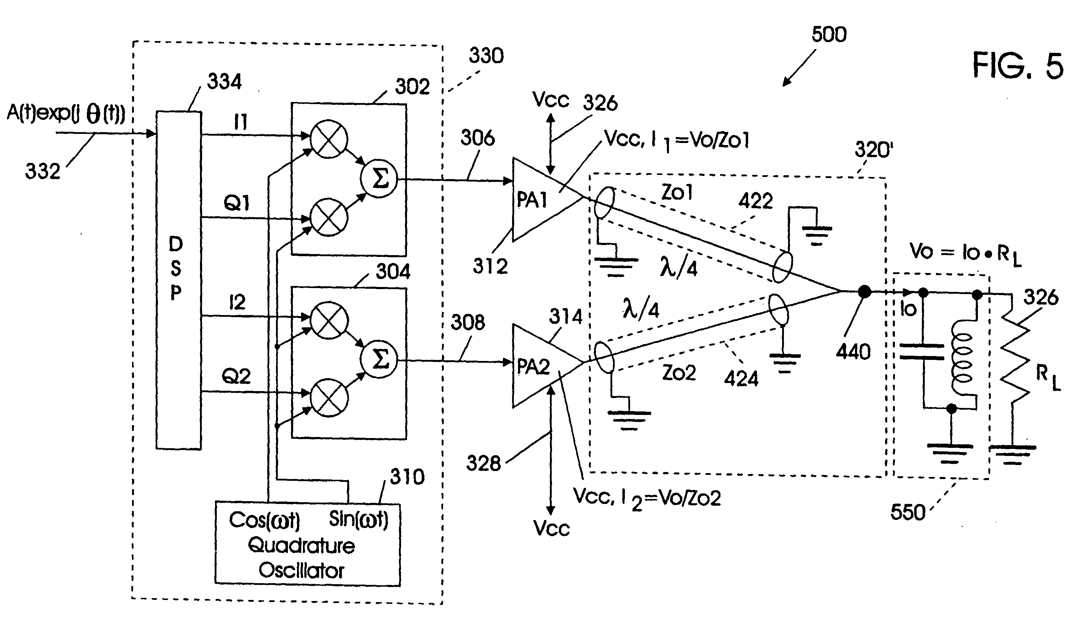

To obtain maximum efficiency, it is desirable to avoid harmonic currents flowing in the power amplifier output circuits. This may be obtained using a series resonant circuit in series with the power amplifier output terminal to present a low impedance to the fundamental and a high impedance to harmonics. However, a single shunt resonant circuit **550** may instead be connected one quarter wave away at the node of the two quarter wave lines, as shown in amplifier **500** of Figure 5. The shunt resonator forces the voltage waveform to be sinusoidal at the junction of the lines (node **440**), and therefore one quarter wave away the current at the power amplifier devices is forced to be sinusoidal.

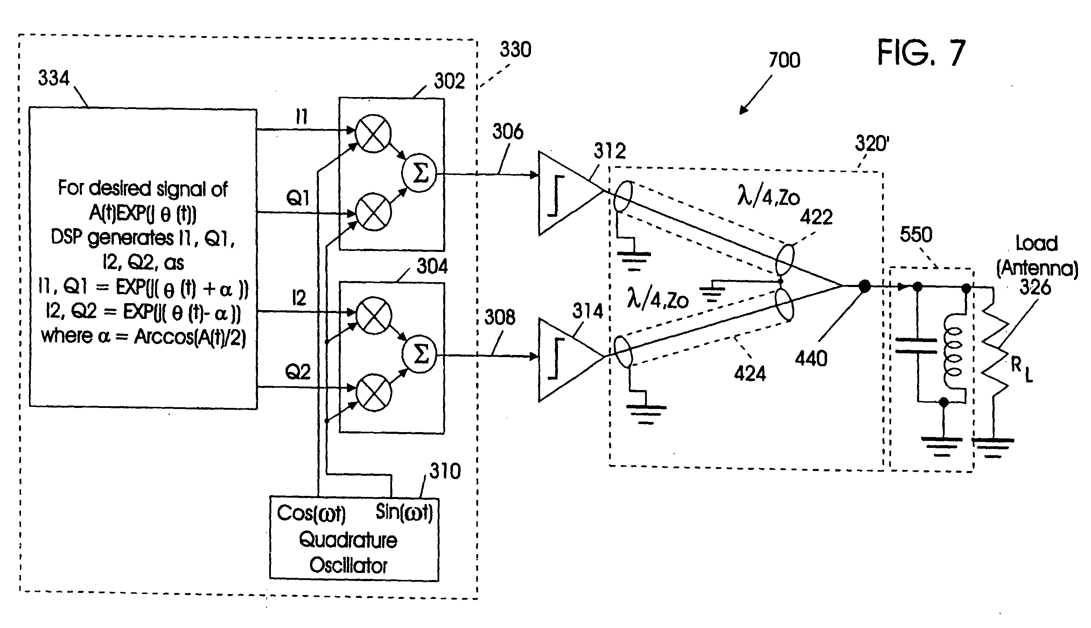

As described above, the first and second amplifiers **312** and **314** respectively preferably include bilateral amplifier devices that draw current from the DC power supply **326** and supply current to the DC power supply. Accordingly, during part of the signal cycle of the AC input signal **332,** current flows from the first and second amplifiers to the DC power supply to return energy to the DC power supply. Figure 6 illustrates a power amplifier including bilateral amplifier devices according to the present invention.

As shown in Figure 6, power amplifier **312** includes a P-type field effect transistor **602** and an N-type field effect transistor **604** that are respectively coupled between positive and negative power supplies **328a** and **328b** respectively. Input signal **332** is coupled to the P-type field effect transistor **602** and the N-type field effect transistor **604.** These field effect transistors produce an output signal that is provided to the quarter wavelength line **422.** Similar considerations apply to second amplifier **314.**

When $\alpha$ is between 0 and 90 degrees, the sinusoidal current in the power amplifier devices is not in phase with the switching of the devices on and off, as illustrated in Figure 6. As also shown in Figure 6, the mean current from the power supplies is reduced by a further factor of cos($\alpha$) relative to the peak current Ipk. Since Ipk also reduces with cos($\alpha$), the net supply current reduces as cos$^2$($\alpha$), which is the same factor by which the output power is reduced by modulating $\alpha$. The supply power and load power both therefore track, maintaining the same theoretical efficiency when backed off as when not. This relies on the use of bilateral power amplifier devices which can pass current in the reverse direction during part of the input signal cycle, returning energy to the battery.

That the theoretical efficiency using ideal bilateral devices is 100% may be understood in the context of a single ended push-pull output stage, as shown in Figure 6. In region "a" from 0 to $(\pi-\alpha)$, the current flows from -Vcc/2 to the load, while the N-type device is on, pulling down. This is delivering energy from -Vcc/2 source **328b** to the load. In region "b", current is still negative, but the P-type device is on. That means current and energy are flowing back towards the +Vcc/2 source **328a**. In region "c", current is flowing from the Vcc/2 **328a** source to the load while the P-type device is on, and in region "d", current is still negative when the N-type device comes on, sending current and energy back to the -Vcc/2 source **328b**. The mean currents are thus:

$$\frac{\mathrm{Ipk}}{2\pi}\left[\int_{0}^{\pi-\alpha}\sin(\theta)\delta\theta - \int_{0}^{\alpha}\sin(\theta)\delta\theta\right] = I_{pk}\cos(\alpha)/\pi$$

from each of the -Vcc/2 and +Vcc/2 supplies, that is reduced by the factor $\cos(\alpha)$ compared to an in-phase current.

In Figure 6, the mean supply currents from the split supplies -Vcc/2 and +Vcc/2 are computed to be Ipk/$\pi$ when $\alpha$=0. The total power from both supplies is therefore:

$$\mathrm{Ipk}\cdot\mathrm{Vcc}/\pi. \tag{1}$$

The square-wave voltage swing at the single-ended power amplifier output is -Vcc/2 to I-Vcc/2 i.e. Vcc/2 peak, so the current at the end of a quarter wave line of impedance Zo must be a square wave of peak current +/- Vcc/2Zo. The fundamental component of a square wave is $4/\pi$ times the peak, so the fundamental current driving the resonator of Figure 5 is:

$$\frac{2\mathrm{Vcc}}{\pi\cdot\mathrm{Zo}}\ \mathrm{peak} \tag{2}$$

The current induces a peak load voltage of:

$$\frac{2\mathrm{Vcc}.R_{L}}{\pi\cdot\mathrm{Zo}} \tag{3}$$

The load power is thus 1/2 x peak current x peak voltage:

$$= \frac{2\mathrm{Vcc}^{2}\cdot R_{L}}{(\pi\cdot\mathrm{Zo})^{2}} \tag{4}$$

Equation (3) gives the sinusoidal voltage swing on the resonator at the end of the quarter wave line. Thus, the current at the power amplifier device end of the line is this divided by Zo, i.e.:

$$\mathrm{Ipk} = \frac{2\mathrm{Vcc}\cdot R_{L}}{\pi\cdot\mathrm{Zo}^{2}} \tag{5}$$

Substituting for Ipk from equation (5) into equation (1) gives the total DC input power as:

$$= \frac{2\mathrm{Vcc}^{2}\cdot R_{L}}{(\pi\cdot\mathrm{Zo})^{2}} \tag{6}$$

which is the same as equation (4), showing that the efficiency is 100%

It is well known that a switch-mode inverter with lossless filtering to convert a square-wave to a sine-wave output gives theoretical 100% efficiency. However, in the arrangement of Figures 3 to 6, which is encapsulated in the transmitter of Figure 7, the efficiency is maintained even for signals of varying amplitude, or when the transmitter is backed off to less than full output. In Figure 7, amplifier **700** can use switch-mode (class-D) power amplifiers. The load **326** is an antenna. Thus, the present invention, which has no theoretical limitations to efficiency, is a better starting point than prior art power amplifiers, the theoretical efficiency of which is already less than 100% even with ideal devices.

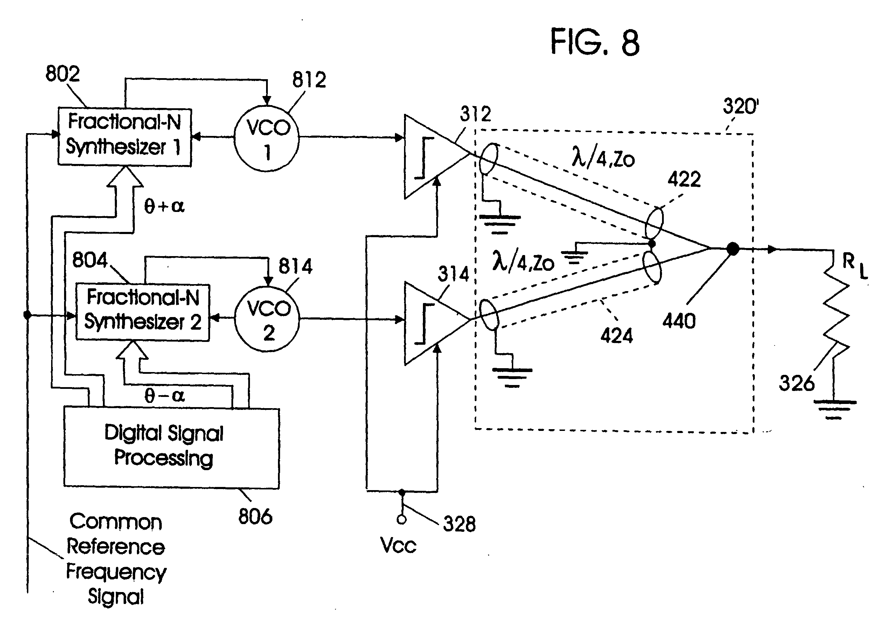

The present invention uses means, such as a digital signal processor (DSP) **334**, to convert a complex modulation signal having a varying amplitude and a varying phase into two modulation signals having constant amplitude and differently varying phases. It then uses means to produce two signals modulated by respective phase modulation signals. One means has been illustrated in Figure 2, namely the use of two quadrature modulators **302, 304** driven respectively by the cosine and sine of their respective phase modulation signals. Another technique is shown in Figure 8 wherein two frequency synthesizers, each modulatable in phase, such as modulatable fractional-N synthesizers **802** and **804** are used. A modulatable fractional-N synthesizer comprises an accumulator whose value determines the phase of an oscillator **812, 814** controlled by the synthesizer. Normally in a fractional-N synthesizer, the accumulator augments continuously (with wraparound) by the repeated addition of a slope value, which provides a frequency offset. To change the phase, the accumulator may be additionally augmented by adding once only a value equal to the change of phase desired. This arrangement is shown in Figure 8.

Using two separate fractional-N synthesizers **802, 804,** the cumulative nature of the delta-phase values added may get out of step. In practice therefore, the need to maintain synchronism suggests that the two synthesizers should be combined into a single chip. Moreover, the type of synthesizer called a " reciprocal fractional-N" disclosed by WO-A-9907066, filed July 30, 1997 and published February 11, 1999, having a priority earlier than the present application may be advantageous, as it modulates the reference divider controlled by a fixed reference frequency, which is then easier to synchronize when two modulated synthesizers are required.

Another directly phase-modulatable synthesizer technique is the Direct Digital Synthesizer or DDS, in which an accumulator computes the value of $(\omega t+\phi)$ continuously and converts the most significant part to a sine wave using a sine look-up table. Any other conventional method of producing phase modulated signals can also be used with the present invention.

Accordingly, a transmit power amplifier for linearly amplifying signals of varying amplitude and phase comprises a signal generator for generating a first amplifier drive signal of constant amplitude and first phase angle and a second amplifier drive signal of constant amplitude and second phase angle such that the combined signals have the desired instantaneous amplitude and phase angle of a signal to be transmitted. The first drive signal is amplified by a first power amplifier using first active amplifier devices and the second drive signal is amplified by a second power amplifier using second active amplifier devices, the first and second amplifier devices preferably being driven to saturation.

The outputs of the first and second power amplifiers are connected using two quarter wave lines each connected to respective active devices at one end and connected to a common junction at their other end. Alternatively, transformers may be used.

A shunt resonant circuit at the common junction can constrain the voltage at the junction to be sinusoidal and proportional to the cosine of half the difference between the first and second phase angle. The shunt circuit can thereby constrain the peak current in the amplifier devices to be sinusoidal and proportional to the same cosine.

The sinusoidal currents in the devices are also out of phase with their respective drive wave forms by plus and minus half the difference between said first and second waveform such that power is taken from a DC supply source during part of the cycle and returned by reverse conduction through an amplifier device during another part of the cycle. The mean current consumed from the DC supply source can thereby be reduced by a further factor equal to the cosine. The net power consumed from the DC source therefore can reduce in proportion to the square of the cosine and in the same ratio as sinusoidal power delivered to the load, thus maintaining the same efficiency at all reduced instantaneous amplitudes as at peak output amplitude, within the limits of practical devices.

The theoretical efficiency of the present linear amplifier using ideal devices is 100% even when backed-off to reduced output levels and thus can be a better starting point for obtaining high efficiency than a prior art amplifier. For example, a class-B type has a theoretical efficiency using ideal devices of only 78.5% at full output.

When the invention is to be used to generate signals that vary both in amplitude and phase, the two constant envelope amplifiers generate signals that vary in phase by the sum and difference respectively of the desired phase variation and an amplitude determining phase component. When the variation of both phase components is in the same direction, the sum phase varies faster; otherwise the difference phase varies faster. One phase thus varies faster than the other and the rate of phase variation can become very large when the desired signal vector has a trajectory that passes close to the origin (0,0) of the complex plane. If the signal vector passes exactly through the origin, i.e. the signal amplitude goes to zero, both phase variations have finite derivatives. However, for a vector that passes infinitesimally close to the origin, the phase derivatives can be arbitrarily large.

It is a potential advantage that constant amplitude signals varying only in phase can be produced using modulated phase locked loops. However, the rate of change of phase produced by a phase locked loop generally is limited by its loop bandwidth. It is desired to avoid using excessively wide loop bandwidths so that the phase locked loop helps to filter out unwanted noise and prevent wideband noise from being transmitted. However, the use of narrow phase locked loops may limit the ability to accurately reproduce complex signal vector trajectories that pass close to the origin. The present invention can resolve this design conflict and can permit the use of more desirable phase locked loop parameters without impacting the accuracy with which complex signal trajectories can be reproduced.

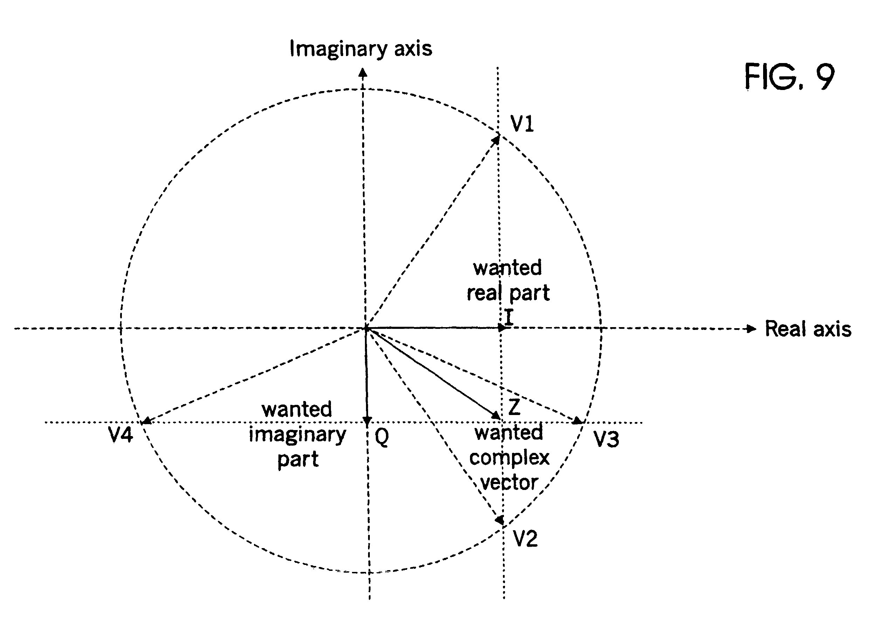

A first aspect is described with the aid of Figure 9. Figure 9 shows synthesis of a complex vector **Z** by separately synthesizing its real part **I** and its imaginary part **Q**. These are each in turn synthesized by adding pairs of constant-amplitude, counter-rotating, variable-phase vectors. Thus, Figure 9 shows addition of four constant amplitude vectors, **V1, V2** (which combine to yield the real part **I**) and **V3, V4** (which combine to yield the imaginary part **Q**).

An advantage of using a pair of vectors to synthesize only the real or the imaginary part is that the trajectory of the real or imaginary part alone must pass through the origin exactly upon changing sign. The rate at which the value passes through zero is limited by the finite bandwidth of the complex signal being synthesized. Thus, the rate of rotation of each of the four vectors **V1, V2, V3** and **V4** may be guaranteed to be finite when synthesizing a finite bandwidth signal. Moreover, each of the vectors only ever has to rotate through +/-90 degrees relative to a mean phase, in order to produce a real or imaginary part varying between plus the maximum and minus the maximum signal amplitude. Thus the design of phase locked loops may be eased compared to the use of only two constant amplitude vectors, where the phase of each vector can need to rotate through the full 360 degrees and continue rotating through any multiple of 360 degrees.

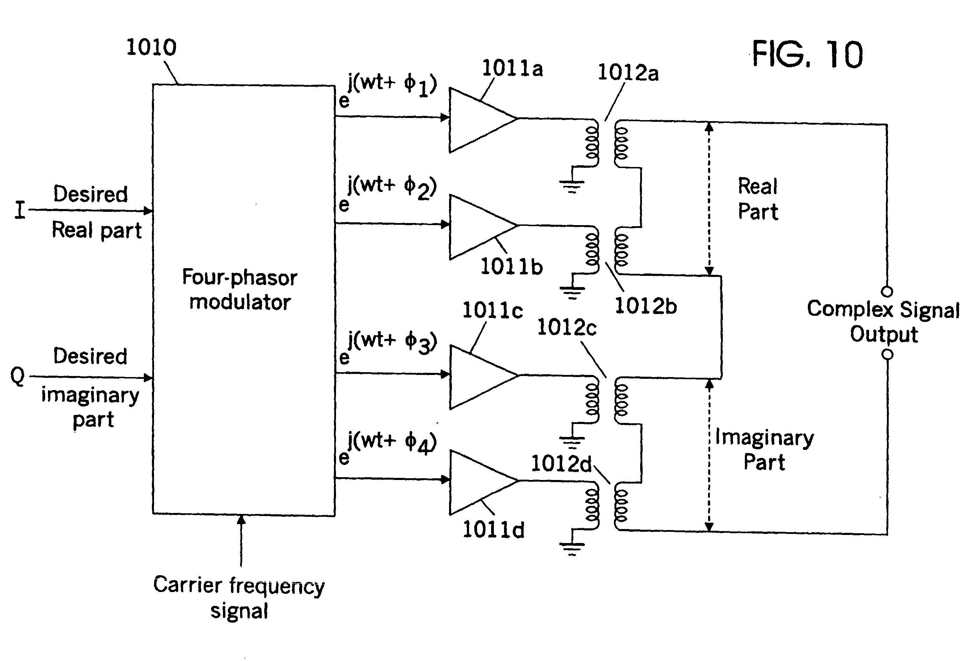

Figure 10 shows an arrangement of four, coupled, constant-amplitude power amplifiers **1011a, 1011b, 1011c,** and **1011d** according to the invention. A four-phasor modulator **1010** is fed with information on the desired signal to be transmitted, which can for example be described by the waveform of the real part **I** (cosine carrier component) of the complex signal and the waveform **Q** of the imaginary part (sine carrier component). Modulator **1010** produces four, constant amplitude, varying phase signals denoted by:

$$e^{(jwt+\phi 1)}$$
$$e^{(jwt+\phi 2)}$$
$$e^{(jwt+\phi 3)}$$

and $e^{(jwt+\phi 4)}$

where $\phi 1$ = ARCCOS(I); $\phi 2 = -\phi 1$; $\phi 3$ = 90-ARCCOS(Q) and $\phi 4$ = 180 - $\phi 3$, and "w" is the frequency of the carrier frequency signal which may be supplied at another input..

Because the ARCCOS function is undefined for arguments greater than unity, the desired signal Z=I+jQ is properly scaled so that its peak amplitude never exceeds unity, and is preferably just less than unity. Scaling to a desired power level is accomplished by amplifiers **1011a.....1011d.** The outputs of amplifiers **1011a,1011b,** corresponding to vectors **V1,V2** of Figure 9, are added in series using transformers **1012a** and **1012b** to produce the real part **I**. The real part **I** will consist of a cosine carrier component only that is modulated in amplitude from positive amplitudes to negative amplitudes, i.e. Double-SideBand, Suppressed Carrier modulation (DSBSC). Likewise, the outputs of amplifiers **1011c, 1011d** corresponding to vectors **V3, V4** of Figure 9 are added in series using transformers **1012c, 1012d** to produce the imaginary part **Q**, which is a DSBSC modulated sine carrier component. The outputs of all transformers are then coupled in series to add **I** and **Q** to obtain the desired complex signal modulation Z = I+jQ.

As disclosed in the parent application WO-A-99/07066, series coupling causes the same output or load current to flow in all amplifier devices, irrespective of their voltage contribution to the total output signal. When that current is in phase with an amplifier's voltage contribution, that amplifier is delivering power from the DC source to the load. When the amplifier's voltage contribution is in antiphase with the load current, that amplifier acts as a synchronous rectifier and returns current to the DC source, providing bilateral output devices are used. When an amplifier's voltage contribution is 90 degrees out of phase with the load current, current is consumed from the DC source during part of the AC signal cycle and returned to the DC source during the other part of the cycle, consuming no net current from the source in the mean. Thus the only mean power consumed by amplifiers **1011a....1011d** from their common DC source (not shown) corresponds to power delivered to the output circuit or load, which therefore corresponds only to the desired signal waveform Z. The theoretical efficiency of the amplifier with ideal bilateral amplifier devices is therefore 100%, in contrast to prior art linear amplifiers that have lower theoretical efficiencies even with ideal devices.

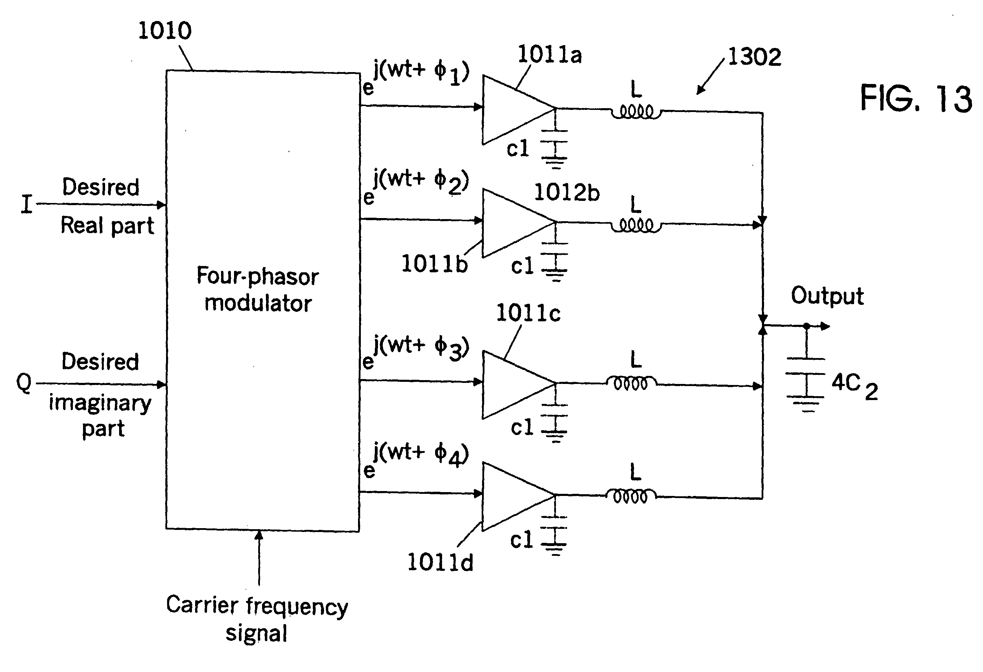

For very high frequency and microwave operation, it was disclosed in the parent application WO-A-99/07066 that a more practical form of series coupling can be to use parallel coupling one quarter wavelength away from the amplifiers, using quarter wave transmission lines of appropriate impedance. The choice of impedance is made to match the amplifiers to the load impedance, e.g. an antenna, for generating the desired total output power. The length of the quarter-wave coupling lines should also be shortened as necessary to compensate for the output capacitance of the amplifier devices. Quarter-wave line equivalent circuits may also be constructed with discrete inductors and capacitors, for example in a Pi-network configuration **1302,** as shown in Figure 13. The first capacitor **C1** of each Pi network **C1, L, C2** can absorb the output capacitance of the amplifier devices while the second capacitors **C2** can be combined into a single capacitance **4C2**. Such networks preferably should be designed to reflect a high impedance at the amplifiers at as many odd harmonics as possible, using additional LC components, and the amplifiers should preferably be push-pull amplifiers that suppress even harmonics of the carrier frequency.

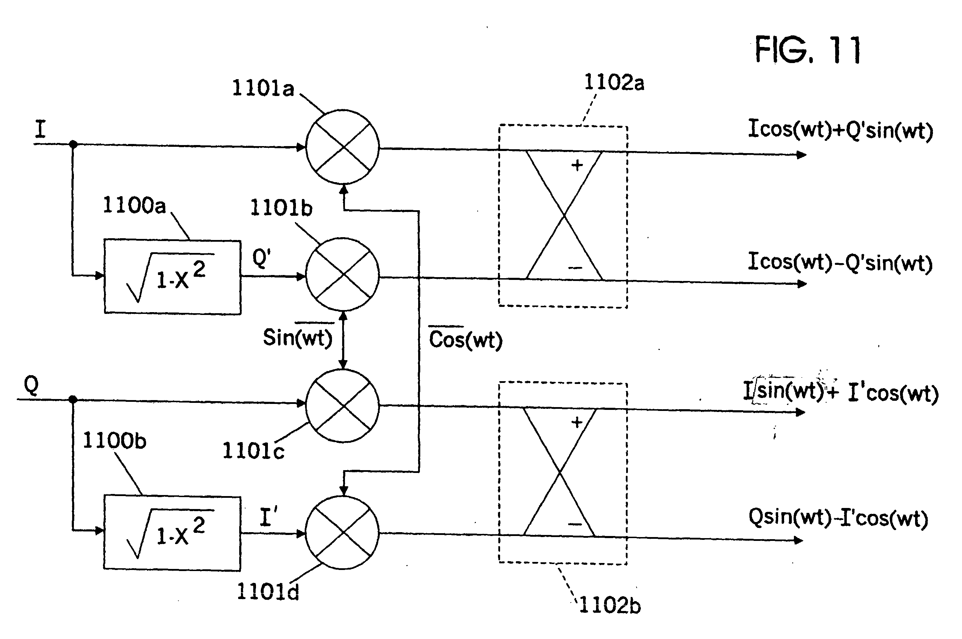

Figure 11 shows more detail of one implementation of a four-phasor modulator **1010** of Figure 10. The **I** signal is fed to a first balanced modulator **1101a** where it multiplies a cosine carrier component to produce Icos(wt). The **I** signal is also fed to function generator **1100a** that derives a signal **Q'** from **I** such that the sum of the squares of **I** and **Q'** is a constant. This is achieved if the function f(x) implemented by the function generator **1110a** is a $\sqrt{1-x^2}$ function. **Q'** is fed to a second balanced modulator **1101b** where it multiplies a sine carrier component to obtain Q'sin(wt). Butterfly circuit **1102a** forms both the sum and the difference of the outputs of modulators **1101a**,**1101b** to obtain:

$$Icos(wt) + Q'sin(wt)$$

and

$$Icos(wt) - Q'sin(wt),$$

both of which have the constant amplitude

$$\sqrt{I^2 + Q^2}.$$

These two constant-amplitude drive signals correspond to vectors **V1** and **V2** of Figure 9 and drive amplifiers **1011a** and **1011b** of Figure 10.

The desired **Q** signal component feeds a similar circuit except that **Q** multiplies the sine carrier component in balanced modulator **1101c** and the derived signal **I'**, derived using function generator **1100b**, multiplies the cosine carrier in balanced modulator **1101d.** Butterfly circuit **1102b** then forms the sum and difference of the outputs of modulators **1101c** and **1101d** to obtain the two constant amplitude signals Qsin(wt) + I'cos(wt) and Qsin(wt) - I'cos(wt), which correspond to vectors **V3** and **V4** of Figure 9, and drive amplifiers **1011c** and **1011d** of Figure 10.

It is common to encode information for transmission and to convert coded information to baseband modulating signals **I** and **Q** using digital signal processing. **I** and **Q** may first be produced using digital signal processing as a sequence of numerical samples, which are then converted to analog waveforms by means of digital to analog (DtoA) convertors. A technique for eliminating the DtoA convertors is described in U.S. Patent Number 5,530,722 to the present inventor.

The technique involves converting the numerical I/Q sample streams to high bitrate, sigma-delta modulation, which can then be converted to analog signals by low-pass filtering.

The balanced modulators **1101a**, **1101b**, **1101c** and **1101d** can, for example, be of the type known as Gilbert Cells, which are easy to fabricate in semiconductor processes. The output signal from a Gilbert Cell is a balanced (i. e. push-pull) current and the output of two Gilbert cells can therefore be added by paralleling their outputs to add their output currents. Reversal of the connections of one Gilbert cell then causes subtraction. Thus the Butterfly circuits **1102a, 1102b** may be obtained by parallel coupling the outputs of Gilbert cells, using a reversal of connections to one Gilbert cell for the difference output. The current outputs from a Gilbert cell may be duplicated using current mirrors in order to obtain one balanced output for forming the sum and a similar balanced output for forming the difference. It is also known from the prior art references mentioned above, for modulating data signals, the entire stigma-delta bitstream may be precomputed and stored in a look-up table for different, finite-length data symbol sequences and recalled by addressing the table with modulating data sequences to obtain the correct sigma-delta waveforms.

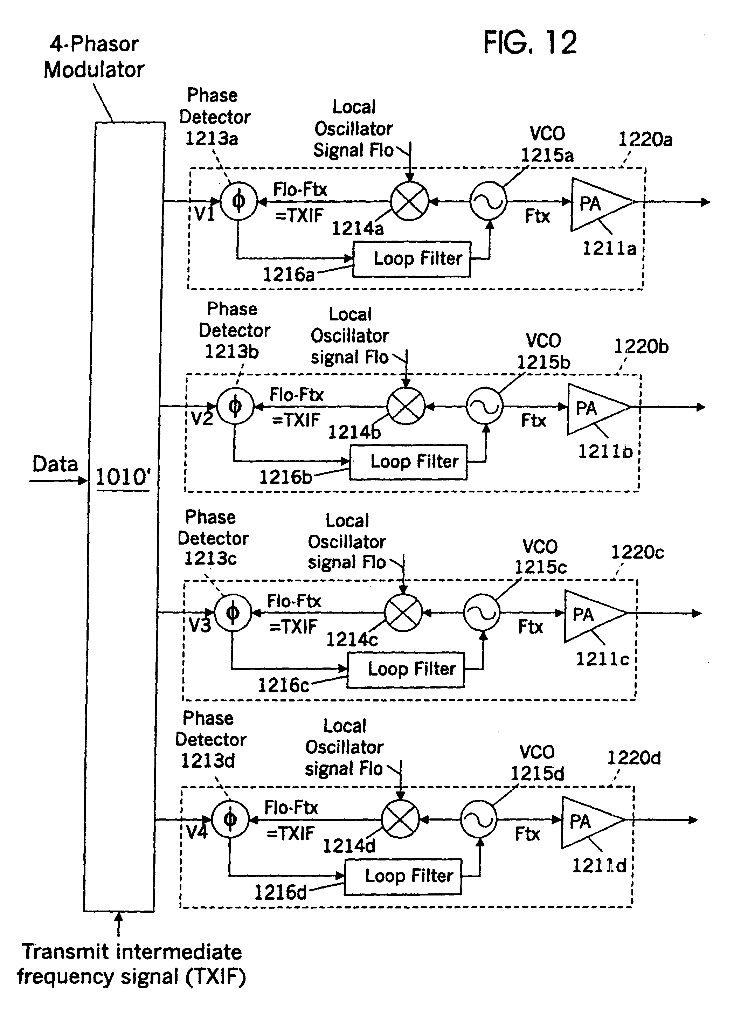

One of the potential benefits of synthesizing a signal for transmission using only phase-modulated signals is that the phase modulation may be applied to an oscillator running directly at the output frequency and with a power output that is higher than that achievable from prior art quadrature modulators. Thus the power amplifier may need less gain to amplify the oscillator output and thus amplifies wideband noise less. Preventing the power amplifier from amplifying wideband noise can help avoid interference from the transmitter to a receiver in the same or in a nearby apparatus, such as a cellular telephone. The technique of first generating a phase modulated signal at a transmit intermediate frequency and then transferring that phase modulation by means of a phase locked loop to a transmit frequency VCO is further described in U.S. Patent No. 5,535,432 to the present inventor, and has been used in cellular phones conforming to the GSM digital cellular standard manufactured by L.M. Ericsson and sold in Europe since 1992. An application of this scheme with the present invention is shown in Figure 12.

Referring now to Figure 12, the four-phasor modulator **1010'** produces phase modulated signals at a transmit intermediate frequency (TXIF). A transmit frequency voltage controlled oscillator **1215a** produces a signal at transmit frequency Ftx which is amplified by power amplifier **1211a**. A portion of the output of oscillator **1215a** is fed to downconverting mixer **1214a** where it is heterodyned with a local oscillator signal of frequency Flo, which is offset from the desired transmit frequency Ftx by the TXIF, i.e.

$$Flo = Ftx +/- TXIF.$$

In a cellular telephone, the local oscillator signal often is the same as already used in the receiving section, which is ensured by choosing TXIF correctly so that the transmit frequency is displaced from the receive frequency by an amount known as the "duplex spacing".

The difference frequency output from heterodyne downconvertor (mixer **1214a**) at a frequency TXIF is phase compared in phase detector **1213a** with the phase-modulated TXIF signal from modulator **1010'**. If the compared phases do not match, a phase error signal is generated by phase detector **1213a** which is integrated in loop filter **1216a** to produce a correcting control signal to VCO **1215a,** thus controlling the phase and frequency of VCO **1215a** to follow the phase modulation from modulator **1010'.**

The entire Phase Locked Loop phase-transfer circuit **1220a** comprising elements **1213a, 1214a, 1215a** and **1216a** and power amplifier **1211a** is replicated as **1220b, 1220c** and **1220d** for the other three phasor channels. Four-phasor modulator **1010'** is shown in Figure 12 having a single data input rather than **I** and **Q** inputs. Thus, 4-phasor modulator **1010'** is assumed to incorporate the conversion of data symbol sequences to **I,Q** waveforms, using, for example, precomputed look-up tables as discussed above.

When the transmit output frequency is to be changed between different channels, it now suffices to change the local oscillator frequency Flo, and the generated transmit signal will change to the new channel in step with the change to Flo. A benefit of using phase locked loops to transfer the phase modulation to the output frequency is that the phase locked loop bandwidth determined by loop filters **16a....16d** need only have a bandwidth sufficient to pass the modulation accurately, and thus can help to reject wideband noise which could otherwise be amplified by power amplifiers **1211a....1211d**, potentially interfering with a receiver.

Another aspect of the invention will now be described that corresponds to the more general inventive principle of synthesizing a vector of variable phase and amplitude by combining more than two vectors of constant amplitude. One special case of combining four vectors was discussed in detail above with the aid of Figures 9 to 13. In that example, the vectors were combined in pairs to produce the real and the imaginary parts of the desired complex signal vector. An objective was to eliminate the likelihood of large rate-of-change of phases being needed on any vector. The excess degrees of freedom available in using more than two constant amplitude vectors to synthesize a complex vector may be more generally targeted to reduce the maximum rate-of-change of phase needed for any vector. The minimum rate-of-change of phase solution would not necessarily turn out to combine two vectors to generate the real part and two vectors to generate the imaginary part, and this would not be the solution if three of five vectors were used.

The general problem may be formulated mathematically as follows:

Find N phase waveforms $\phi(1)....\phi(N)$ such that

$$\sum_{k=1}^{N} e^{j\phi(k)} = Z(t), \text{ a desired complex waveform}$$

and the largest $|\dot{\phi}(k)|$ is minimized.

An alternative goal is to minimize the sum of the squares of the phase derivatives, i.e.:

Find N phase waveforms $\phi(1)....\phi(N)$ such that

$$\sum_{k=1}^{N} e^{j\phi(k)} = Z(t), \text{ a desired complex waveform}$$

and

$$\sum_{k=1}^{N} |\dot{\phi}(k)|^2 \text{ is minimized.}$$

The above can be restated as a standard Lagrange multiplier problem as:

$$\text{Minimize } \sum_{k=1}^{N} |\dot{\phi}(k)|^2 \text{ subject to } \sum_{k=1}^{N} je^{j\phi(k)} \phi(k) = Z(t)$$

Splitting the above complex equation involving Z into its real and imaginary constituent waveforms I and Q, and defining the 2 x N matrix A as:

$$[A] = \begin{bmatrix} \cos(\phi 1)\cos(\phi 2)......\cos(\phi_N) \\ \sin(\phi 1)\sin(\phi 2)......\sin(\phi_N) \end{bmatrix}$$

the Lagrange multiplier problem has the solution:

$$\begin{pmatrix} \dot{\phi}1 \\ \dot{\phi}2 \\ \vdots \\ \dot{\phi}_N \end{pmatrix} = A^{\#}[A.A^{\#}]^{-1} \begin{pmatrix} \dot{Q}(t) \\ -\dot{I}(t) \end{pmatrix}$$

The above equation is a set of N, non-linear differential equations which can in principle be solved for the N phase waveforms, given the desired complex signal waveform Z(t), in terms of its real part I(t) and its imaginary part Q(t). Such a solution may be onerous to perform in real time, but as digital processors become ever more powerful and the real-time solution method may soon, if not already, be an economically practical implementation. The problem can be stated in discrete time steps of dt to obtain phase waveform samples in steps of dt, given the values of Z(t) at discrete steps dt as Z1=I1+jQ1; Z2=I2+jQ2....etc.

The values of the phases at time step number "i" can then be derived from the above differential equation to be:

$$\begin{pmatrix} \phi 1 \\ \phi 2 \\ \vdots \\ \phi_N \end{pmatrix}_i = A^{\#}[A.A^{\#}]^{-1} \begin{pmatrix} Q(i)-\overline{Q}(i-1) \\ \overline{I}(i-1)-I(i) \end{pmatrix} + \begin{pmatrix} \phi 1 \\ \phi 2 \\ \vdots \\ \phi_N \end{pmatrix}_{i-1}$$

where $\overline{I}, \overline{Q}$ are the previously achieved values given by

$$\overline{I}(I-1)+j\overline{Q}(I-1) = \sum_{k=1}^{N} e^{j\phi k(i-1)}.$$

The use of the previously achieved I,Q values at timestep (i-1) as the stepping-off point from which to reach

**EP 1 068 666 B1**

the new desired I,Q values at timestep "i" can ensure that computational errors such as rounding errors in the previously achieved values are compensated by computing the step change in the phase values necessary to move from the previously achieved values, including error, to the new desired values. Thus, computational errors may be prevented from accumulating.

In the above, the matrix A is computed again from the new phase values after every step. Also after every step, the new phase values are applied to a phase modulator, which can include any or all of digital to analog conversion of the phase values, filtering of the converted phase values, phase locked loops for transferring phase modulation to a desired transmitter output frequency, phase modulatable frequency synthesizers such as fractional-N synthesizers or Direct Digital Synthesizers (DDS), or alternatively reconversion of phase values to I,Q values using a Cosine/Sine function or table followed by the use of quadrature modulators to modulate each pair of I and Q values on to a desired radio frequency carrier signal to obtain N constant amplitude signals whose sum will be the desired phase and amplitude modulated signal.

When the desired modulation arises from a digital information signal, the computation can often be simplified, by utilizing the fact that the complex modulation waveform Z(t) is at each time a function of only a limited number L of past and future digital information symbols. Thus there are at each time only a limited number $M^L$ of possible values of Z(t) that can arise, where M is the size of the alphabet of possible information symbols. All possible waveforms of Z(t) can thus be precomputed for all possible sequences of M symbols. Likewise, using the above equations, all possible sets of N phase waveforms can be precomputed and associated with symbol sequences in a waveform look-up table. Actual information symbol sequences are then applied to address the table to extract the precomputed phase waveforms or equivalent I,Q waveforms, thus saving on real-time computation required. One advantage of precomputation is to detect and then avoid any tendency of the matrix $A.A^\#$ to become singular by taking an alternative route between successive points that may temporarily depart from the minimum rate-of-change of phase solution in order to avoid the need for a greater rate of change of phase later.

Accordingly, an amplitude and phase-varying signal may be generated efficiently at a power level for transmission, based on series combining (or the equivalent) more than two amplified signals of constant power level. General methods and systems for computing the required phase variations of each of the constant amplitude signals have been presented which may be used for three or more signals. Specific methods and systems for generating and combining four signals have also been presented, which may be simpler and may be a preferred solution. All variations based on the above teachings which may be made by a person skilled in the art are considered to fall within the spirit and scope of the invention as described by the following claims.

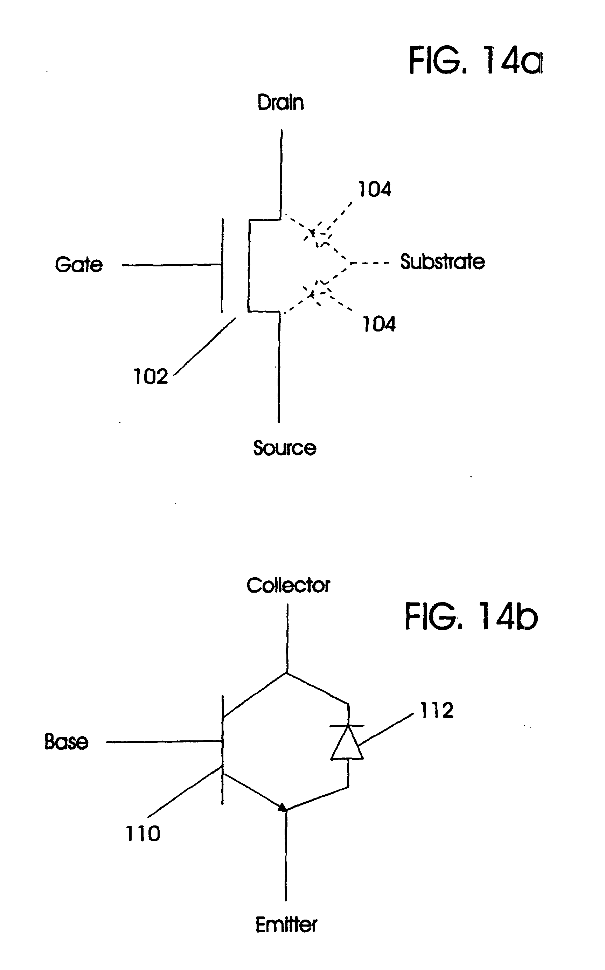

The present invention uses bilateral amplifier devices that can be turned on and off, and which can pass current in either direction when turned on. Figures 14a and 14b illustrate the circuit symbols of conventional bilateral devices that are suitable for use in the invention. Figure 14a shows an N-type FET **102** including its incidental substrate diodes **104.** The FET **102** becomes a low impedance to currents flowing from either drain to source or vice versa. By connecting substrate to source, the incidental drain-substrate diode also assists in reverse current flow from source to drain. However, this connection is not necessary with an FET.

Figure 14b shows a bipolar transistor **110** with a reverse conduction diode **112** added externally. When current attempts to flow in the reverse direction in a bipolar transistor, reversing the roles of emitter and collector, the reverse current gain is generally much lower than the forward current gain, such that the control current supplied to the base may have to be increased excessively in order to support the reverse current. The use of an external reverse conduction diode **112** allows reverse current to flow through the diode without relying upon the transistor's reverse current gain.

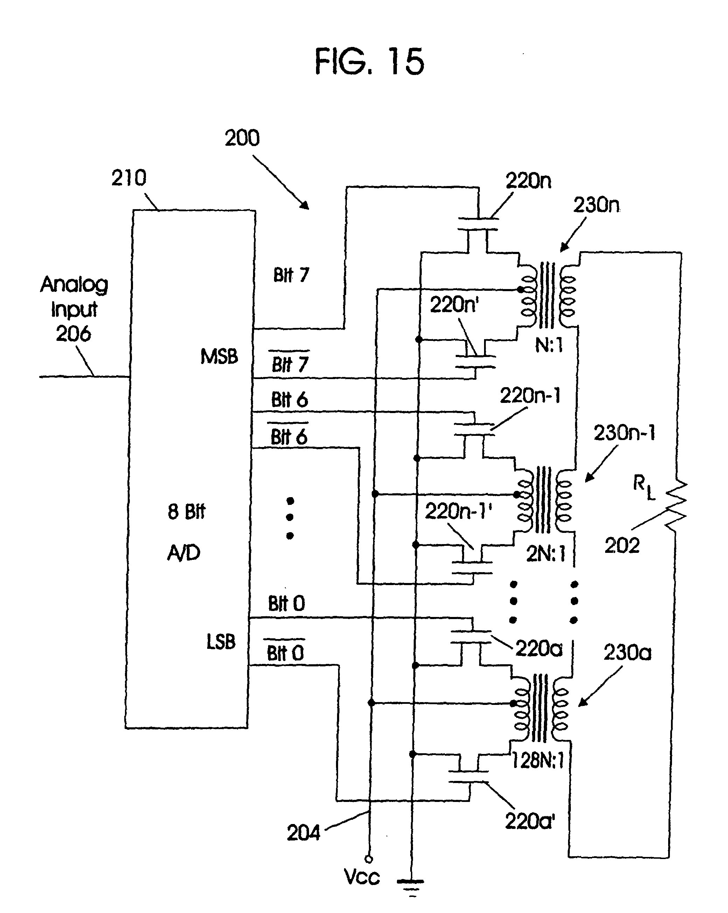

Using any suitable bilateral device such as exemplified in Figures 14a and 14b, the invention may be constructed according to Figure 15.

Referring to Figure 15, a synthesizing apparatus **200** according to the present invention, synthesizes an output waveform in a load $R_L$ **202** using a DC power supply Vcc **204** from an input waveform **206.** Synthesizing apparatus **200** includes means, such as an analog-to-digital (A to D) converter **210** for representing the input waveform **206** as a sequence of numerical codes in a number base. Each numerical code comprises a plurality of digits ordered by place significance. In Figure 15, the representing means is a binary 8-bit analog-to-digital converter, so that the plurality of digits are bit 0-bit 7 and $\overline{bit\,0}$ - $\overline{bit\,7}$, ordered by powers of two.

Still referring to Figure 15, a plurality of bilateral amplifying means each includes a pair of bilateral devices **220a, 220a'-220n, 220n'.** The bilateral amplifiers may comprise either of the bilateral devices shown in Figures 1a or 1b or any other bilateral device. Each bilateral device **220a, 220a'-220n, 220n'** consumes current from the DC power supply Vcc **204** and returns current to the DC power supply based on the value of the associated digit, to thereby generate an output voltage level that is proportional to the value of the associated digit.

Finally, referring to Figure 15, means is provided for serially coupling the output voltage levels of the plurality of bilateral amplifying means to the load $R_L$ **202** with a weighting that is based upon the place significance of the associated digit. As shown in Figure 15, the serially coupling means preferably comprises a plurality of transformers **230a-230n.** Each transformer has a primary and a secondary. The secondaries are serially coupled to the load **202.**

A respective one of the primaries is coupled to a respective one of the bilateral amplifying means **220.** The primary-to-secondary turns ratios of the plurality of transformers **230a-230n** are proportional to the place significance of the associated digit. It will be understood that the designation primary and secondary is arbitrary and may be reversed.

Additional description of waveform synthesizers of Figure 15 will now be provided.

A signal waveform to be amplified to a high power level is fed to an 8-bit analog-to-digital (A/D) converter **210** to generate an 8-bit representation of the waveform at a plurality of sampling points in time. The sampling rate should conform to at least the Nyquist rate for the waveform of twice the maximum frequency obtained in the waveform. However, the sampling rate is preferably many times greater than the Nyquist rate to reduce the need for stringent filtering of the amplified signal to remove quantization noise. If the waveform is repetitive, as in a DC-to-AC power converter application, or comprises a limited number of variants, as in a radio transmitter for transmitting digital data, the numerical samples can be precomputed and stored in a memory, and the A/D converter **210** can then be omitted in favor of direct digital representation of an input waveform as a sequence of numerical codes.

The numerical samples are a binary coded representation of the instantaneous signal voltage having a most significant bit (MSB) that represents ±0.5, a next most significant bit that represents ±0.25, a third most significant bit that represents ±0.125, etc., down to the least significant bit (LSB) which, in the case of an 8-bit converter, represents ±1/256. When all the bits are of the same positive polarity, e.g. all binary 1s, the voltage represented is 0.5+0.25+0.125....+1/256 = 255/256 which is nearly +1. Conversely, when all the bits are of negative polarity, i.e. 00000000, the voltage represented is -0.5-0.25....-1/256 = -255/256 which is nearly -1. These are normalized representations, relative to some maximum voltage. Scaling of the actual switched DC source voltage to an AC output voltage is effected with the aid of transformers **230a-230n**.

The most significant bit, bit-7 is used to control a most significant inverter **220n-220n'** connected to the load circuit via an N:1 transformer **230n**. The value of the turns ratio N is chosen to be the reciprocal of the bit weight (1/0.5 = 2 for the most significant bit) times the ratio of the DC supply voltage to the desired peak AC output voltage. The turns ratio N thus successively doubles for bits of progressively lower bit weight as shown in Figure 15 by the ratios N:1, 2N:1, 4N:1....128N:1 for the transformers of successively lower significance.

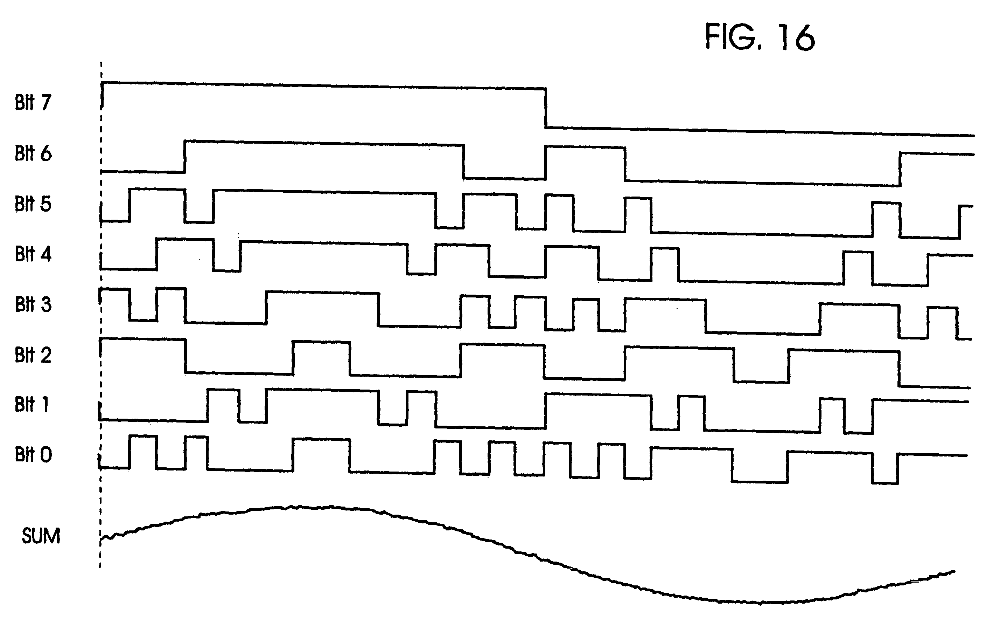

Figure 16 shows the unfiltered output waveform and the waveforms of the individual bits when synthesizing a sinewave output using 32 time samples per cycle. In these waveforms, quadrential symmetry has been enforced by computing the 8-bit representations for the first 8 sample points and time-reversing them for the next 8. The second 16 samples are then given the code complementary to the first 16 samples. Each bit waveform thereby possesses ± symmetry, so that it will pass through a transformer. The weighted sum of the bits, i.e. the load voltage, showing the purity of the synthesized sinewave, is also shown in Figure 16, as **SUM**.

It may be seen that the most significant bit, which can be thought of as a sign bit, changes in a square-wave fashion at the fundamental frequency. The bits of lower significance, as well as being of progressively half the voltage significance, change at a faster rate. Thus, the amount of magnetic material or copper in the output transformers of lower significance may be reduced due to both the reduced voltage and power level they have to handle and also due to the higher alternation frequency.

It will be noted in Figure 16 that, while the most significant bit is always positive during the first (positive) half cycle of the sinewave output, bits of lower significance are often negative, which means that their contribution is being subtracted from the net output voltage. The inverters associated with bits that are subtracting from the magnitude of the output voltage thus have an output current flow which is in the opposite direction to the output voltage. This means that the output device of that inverter which is in the ON state is not absorbing power from the DC supply, but is returning current to the DC supply by virtue of the bilateral inverter device conducting current in the reverse direction.

The operation of synthesizer **200** of Figure 15 as an audio amplifier or medium frequency radio transmitter output stage is similar to its operation as a DC-AC power converter. The transformers should be properly designed to operate efficiently in the desired frequency range. Using the invention, very linear and efficient single-sideband (SSB) transmitters may be constructed, for example in the 1-30MHz radio frequency range.

It is also possible to synthesize a sinusoidal output waveform based on a sampled and ternary coded representation. A ternary coded representation comprises, for each sample, a multi-digit code, the digits of which represent either +1, 0 or -1. Digits of lower significance then have one third the weight of digits of the next highest significance. Since $3^5$ is 243 and $2^8$ is 256, five ternary digits can represent approximately the same purity as an 8-bit version of the invention using only 5 ternary stages.

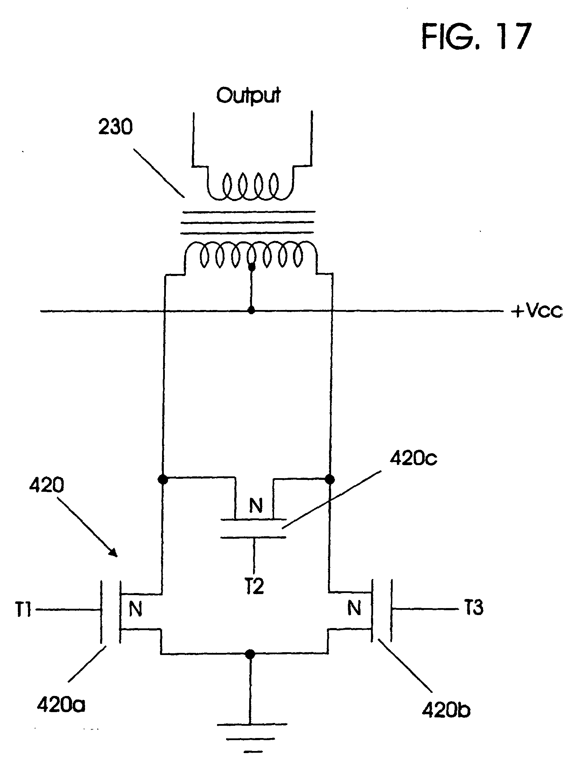

A ternary bilateral amplifier **420** is shown in Figure 17. An extra transistor **420c** is connected between the ends of the transformer primary **230**, compared to Figure 15. When this extra transistor is turned ON after ensuring that the other two transistors **420a** and **420b** are OFF, it will short circuit the primary of the transformer **230** ensuring that the voltage contribution to the output is zero; i.e. the third ternary state. The third, shorting transistor **420c** should preferably be a completely symmetrical device having the same voltage handling capability and transconductance upon reversal of the roles of source and drain electrodes.

The gate control voltage enabled by the control signal **T2** should be greater than $Vcc+V_{threshold}$ in order to turn the device ON, and should be less than $V_{threshold}$ in order to turn the device OFF. The relation between the three control signals **T1, T2**, **T3** and the selected ternary level is shown in the Table below, with a binary "1" indicating that the control voltage is at the ON level and a "0" indicating the OFF level.

Table

| LEVEL: | -1 | 0 | +1 |
|---|---|---|---|
| T1 | 1 | 0 | 0 |
| T2 | 0 | 1 | 0 |
| T3 | 0 | 0 | 1 |

Apart from reduction of the number of stages for the same waveform accuracy, ternary systems may also prevent flux build-up in transformers due to slight asymmetries (center tap position for example). In addition, the relative scaling of 3:1 in voltage between successive stages can allow a more rapid reduction in transformer size for the lower significant digits.

A set of ternary control signals **T1, T2, T3** may be generated by a ternary A/D converter for an arbitrary signal to be amplified in real time. A ternary A/D converter may comprise a binary A/D converter followed by a binary-to-ternary code converter, which may be a look-up table. For a repetitive waveform, or for a limited number of waveforms such as encountered when modulating a radio signal with digital data streams, sequences of control signals **T1, T2, T3** may be precomputed and stored in memory, being recalled from memory in the proper sequence when needed using conventional Read Only Memory modulation generators.

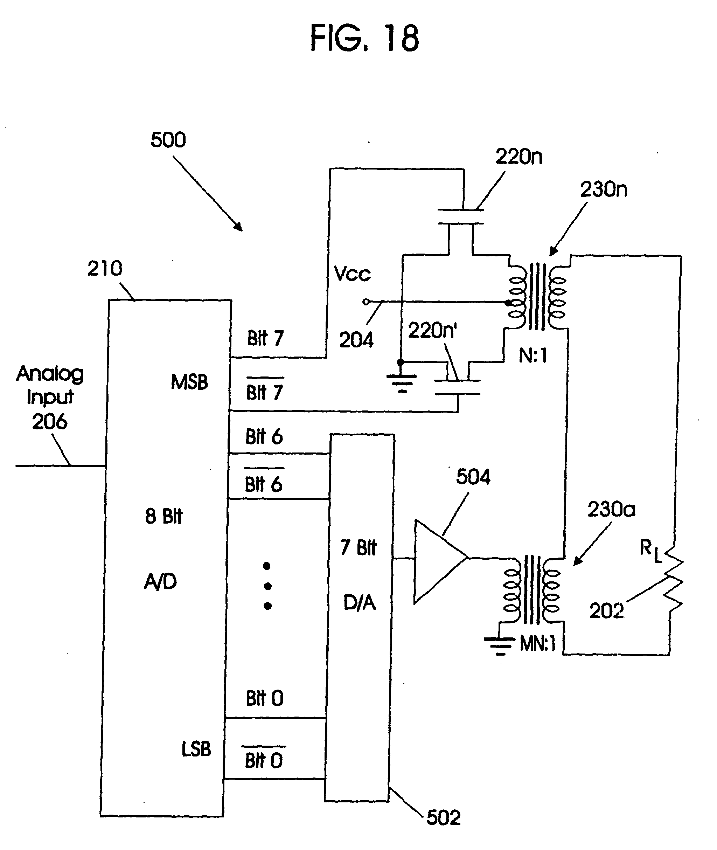

According to another aspect of the invention, all of the inverters below a given bit significance may be replaced with a linear class-B amplifier or other amplifier that generates the same contribution to the voltage waveform, albeit with lower efficiency. The loss of efficiency may be small if confined to generating the lower significant parts. For example, as shown in Figure 18, synthesizing apparatus **500** replaces all inverters except for that of greatest bit significance by a class-B amplifier **504** that is coupled to AID converter **210** by a D/A converter **502.** Transformer **230a** has a turns ratio of MN:1, where M is the number base of the digital signal representation (e.g. 2 for binary and 3 for ternary). It may be shown that the theoretical efficiency drops from 100% to $\pi/2 \sqrt{3}$, which is of the order of 90%. Thus, a trade-off may be made between maximum theoretical efficiency and the number of transformer-coupled stages, i.e. cost.

Many variations may be made by persons skilled in the art, such as, for example, the use of single-ended push-pull amplifiers, having their outputs connected in series with the aid of transformers.

Accordingly, power amplifiers for linearly amplifying a signal waveform include a signal generator for generating a sampled, digital representation of the signal to be amplified, each sample being represented by a numerical code having a number of significant bits from most significant to least significant.

Each bit of the numerical code drives the input of an associated, saturated push-pull amplifier such that the amplifier generates an output of one polarity when the control bit is a binary "1" and an output of the opposite polarity when the control bit is a binary "0". Each amplifier is connected to a prime power source, such as a DC or battery supply. The outputs of the amplifiers are coupled in series with a load into which the amplified signal waveform is to be delivered, such that their respective output voltages are summed in proportion to the significance of their associated code bits and such that the same load current flows in the output terminals of each amplifier.

A preferred series coupling comprises, at the output of each amplifier, a transformer having a primary winding and a secondary winding with turns ratios of N:1, 2N:1, 4N:1...etc., with an increase of two in the ratio for each bit of lower significance.

The amplifiers are constructed using bilateral devices that pass current in either direction when biased to the ON state. When an associated control bit is of such a polarity as to cause the associated amplifier output to subtract from the voltage sum and to thus be of opposite polarity to the direction of load current flow, the current flow in the amplifier devices is reversed, returning energy to the prime power source that is not needed to sustain the load current.

It may be shown that amplifiers according to the invention can have a theoretical efficiency, using ideal bilateral devices, of 100% for any signal waveform, and is thus a better starting point for obtaining practically efficient amplifiers than prior art amplifiers that had less than 100% efficiency even in theory. The invention may be used efficiently to amplify to a transmit power level a radio signal that varies in amplitude as well as phase. Alternatively, the invention may be used as a DC-to-AC converter having a sinusoidal output waveform.

In the drawings and specification, there have been disclosed typical preferred embodiments of the invention and, although specific terms are employed, they are used in a generic and descriptive sense only and not for purposes of limitation, the scope of the invention being set forth in the following claims.

**Claims**

1.  A method for generating from a signal (332) of varying amplitude and varying phase, a plurality of constant amplitude varying phase signals (V1, V2, V3, V4), the sum of which is the signal (Z) of varying amplitude and varying phase, the method **characterized by**:

    generating a cosine carrier modulation waveform I(t) and a sine carrier modulation waveform Q(t) from the signal of varying amplitude and varying phase;
    generating (1100a) a complementary waveform Q'(t) from the cosine carrier modulation waveform I(t) such that the sum of the squares of I(t) and Q'(t) is constant;
    modulating (1101a) a cosine carrier signal with I(t) to obtain a first modulated cosine carrier;
    modulating (1101b) a sine carrier signal with Q'(t) to obtain a first modulated sine carrier; and
    forming (1102a) a sum and difference of the first modulated cosine carrier and the first modulated sine carrier to obtain a first set of constant amplitude varying phase signals (V1, V2).

2.  A method according to claim 1, further comprising the steps of:

    generating (1100b) a complementary waveform I'(t) from the sine carrier modulation waveform Q(t) such that the sum of the squares of I'(t) and Q(t) is constant;
    modulating (1101c) a sine carrier signal with Q(t) to obtain a second modulated sine carrier;
    modulating (1101d) a cosine carrier signal with I'(t) to obtain a second modulated cosine carrier; and
    forming (1102b) a sum and difference of the second modulated cosine carrier and the second modulated sine carrier to obtain a second set of constant amplitude varying phase signals (V3, V4).

3.  A system for generating from a signal (332) of varying amplitude and varying phase, a plurality of constant amplitude varying phase signals (V1, V2, V3, V4), the sum of which is the signal (Z) of varying amplitude and varying phase, the system **characterized by**:

    means for generating a cosine carrier modulation waveform I(t) and a sine carrier modulation waveform Q(t) from the signal of varying amplitude and varying phase;
    means (1100a) for generating a complementary waveform Q'(t) from the cosine carrier modulation waveform I(t) such that the sum of the squares of I(t) and Q'(t) is constant;
    means (1101a) for modulating a cosine carrier signal with I(t) to obtain a first modulated cosine carrier;
    means (1101b) for modulating a sine carrier signal with Q'(t) to obtain a first modulated sine carrier; and
    means (1102a) for forming a sum and difference of the first modulated cosine carrier and the first modulated sine carrier to obtain a first set of constant amplitude varying phase signals (V1, V2).

4.  A system according to claim 3 further comprising:

    means (1100b) for generating a complementary waveform I'(t) from the sine carrier modulation waveform Q(t) such that the sum of the squares of I'(t) and Q(t) is constant;
    means (1101d) for modulating a cosine carrier signal with I'(t) to obtain a second modulated cosine carrier;
    means (1101c) for modulating a sine carrier signal with Q(t) to obtain a second modulated sine carrier; and
    means (1102b) for forming a sum and difference of the second modulated cosine carrier and the second modulated sine carrier to obtain a second set of constant amplitude varying phase signals (V3, V4),

**Patentansprüche**

1.  Verfahren zum Generieren aus einem Signal (332) von variierender Amplitude und variierender Phase einer Vielzahl von Signalen konstanter Amplitude mit variierender Phase (V1, V2, V3, V4), die Summe von denen das Signal (Z) von variierender Amplitude und variierender Phase ist, wobei das Verfahren **gekennzeichnet ist durch**:

    Generieren einer Cosinusträger-Modulationswellenform I(t) und einer Sinusträger-Modulationswellenform Q(t) aus dem Signal von variierender Amplitude und variierender Phase;

    Generieren (1100a) einer komplementären Wellenform Q'(t) aus der Cosinusträger-Modulationswellenform I(t) derart, dass die Summe der Quadrate von I(t) und Q'(t) konstant ist;

Modulieren (1101a) eines Cosinusträgersignals mit I(t), um einen ersten modulierten Cosinusträger zu erhalten;

Modulieren (1101b) eines Sinusträgersignals mit Q'(t), um einen ersten modulierten Sinusträger zu erhalten; und

Bilden (1102a) einer Summe und Differenz des ersten modulierten Cosinusträgers und des ersten modulierten Sinusträgers, um eine ersten Menge von Signalen konstanter Amplitude mit variierender Phase (V1, V2) zu erhalten.

2. Verfahren nach Anspruch 1, ferner die Schritte umfassend:

Generieren (1100b) einer komplementären Wellenform I'(t) aus der Sinusträger-Modulationswellenform Q(t) derart, dass die Summe der Quadrate von I'(t) und Q(t) konstant ist;

Modulieren (1101c) eines Sinusträgersignals mit Q(t), um einen zweiten modulierten Sinusträger zu erhalten;

Modulieren (1101d) eines Cosinusträgersignals mit I'(t), um einen zweiten modulierten Cosinus zu erhalten;

Bilden (1102b) einer Summe und Differenz des zweiten modulierten Cosinusträgers und des zweiten modulierten Sinusträgers, um eine zweite Menge von Signalen konstanter Amplitude mit variierender Phase (V3, V4) zu erhalten.

3. System zum Generieren aus einem Signal (332) von variierender Amplitude und variierender Phase einer Vielzahl von Signalen konstanter Amplitude mit variierender Phase (V1, V2, V3, V4), die Summe von denen das Signal (Z) von variierender Amplitude und variierender Phase ist, wobei das System **gekennzeichnet ist durch**:

Mittel zum Generieren einer Cosinusträger-Modulationswellenform I(t) und einer Sinusträger-Modulationswellenform Q(t) aus dem Signal von variierender Amplitude und variierender Phase;

Mittel (1100a) zum Generieren einer komplementären Wellenform Q'(t) aus der Cosinusträger-Modulationswellenform I(t) derart, dass die Summe der Quadrate von I(t) und Q'(t) konstant ist;

Mittel (1101a) zum Modulieren eines Cosinusträgersignals mit I(t), um einen ersten modulierten Cosinusträger zu erhalten;

Mittel (1101b) zum Modulieren eines Sinusträgersignals mit Q'(t), um einen ersten modulierten Sinusträger zu erhalten; und

Mittel (1102a) zum Bilden einer Summe und Differenz von dem ersten modulierten Cosinusträger und dem ersten modulierten Sinusträger, um eine erste Menge von Signalen konstanter Amplitude mit variierender Phase (V1, V2) zu erhalten.

4. System nach Anspruch 3, ferner umfassend:

Mittel (1100b) zum Generieren einer komplementären Wellenform I'(t) aus der Sinusträger-Modulationswellenform Q(t) derart, dass die Summe der Quadrate von I'(t) und Q(t) konstant ist;

Mittel (1101d) zum Modulieren eines Cosinusträgersignals mit I'(t), um einen zweiten modulierten Cosinusträger zu erhalten;

Mittel (1101c) zum Modulieren eines Sinusträgersignals mit Q(t), um einen zweiten modulierten Sinusträger zu erhalten; und

Mittel (1102b) zum Bilden einer Summe und Differenz von dem zweiten modulierten Cosinusträger und dem zweiten modulierten Sinusträger, um eine zweite Menge von Signalen konstanter Amplitude mit variierender Phase (V3, V4) zu erhalten.

## EP 1 068 666 B1

**Revendications**

1. Procédé pour générer, à partir d'un signal (332) d'une amplitude variable et d'une phase variable, plusieurs signaux (V1, V2, V3, V4) à amplitude constante et phase variable dont la somme est le signal Z d'amplitude variable et de phase variable, le procédé étant **caractérisé par** :

   la génération d'une forme d'onde I (t) de modulation de porteuse cosinus et d'une forme d'onde O (t) de modulation de porteuse sinus à partir du signal d'amplitude variable et de phase variable ;
   la génération (1100a) d'une forme d'onde complémentaire Q' (t) à partir de la forme d'onde I (t) de modulation de porteuse cosinus telle que la somme des carrés de I (t) et Q' (t) est constante.
   la modulation (1101a) d'un signal de porteuse cosinus avec I (t) pour obtenir une première porteuse cosinus modulée ;
   la modulation (1101b) d'un signal de porteuse sinus avec Q' (t) pour obtenir une première porteuse sinus modulée ; et
   la formation (1102a) d'une somme et d'une différence de la première porteuse cosinus modulée et de la première porteuse sinus modulée pour obtenir un premier ensemble de signaux (V1, V2) d'amplitude constante et de phase variable.

2. Procédé selon la revendication 1, comprenant en outre les étapes de :

   génération (1100b) d'une forme d'onde complémentaire I' (t) à partir de la forme d'onde Q (t) de modulation de porteuse sinus telle que la somme des carrés de I' (t) et Q (t) est constante ;
   la modulation (1101c) d'un signal de porteuse sinus avec Q (t) pour obtenir une seconde porteuse sinus modulée ;
   la modulation (1101d) d'un signal de porteuse cosinus I' (t) pour obtenir une seconde porteuse cosinus modulée ;
   la formation (1102b) d'une somme et d'une différence de la seconde porteuse cosinus modulée et de la seconde porteuse sinus modulée pour obtenir un second ensemble de signaux (V3, V4) d'amplitude constante et de phase variable.

3. Système pour la génération à partir d'un signal (332) d'amplitude variable et de phase variable de plusieurs signaux (V1, V2, V3, V4) d'amplitude constante et de phase variable dont la somme est le signal Z d'amplitude variable et de phase variable, le système étant **caractérisé par** :

   un moyen destiné à générer une forme d'onde I (t) de modulation de porteuse cosinus et une forme d'onde Q (t) de modulation de porteuse sinus à partir du signal d'amplitude variable et de phase variable ;
   un moyen (1100a) destiné à générer une forme d'onde complémentaire Q' (t) à partir de la forme d'onde I (t) de modulation de porteuse cosinus telle que la somme des carrés de I (t) et Q' (t) est constante ;
   un moyen (1101a) destiné à moduler un signal de porteuse cosinus avec I (t) pour obtenir une première porteuse cosinus modulée ;
   un moyen (1101b) destiné à moduler un signal de porteuse sinus avec Q' (t) pour obtenir une première porteuse sinus modulée ;
   un moyen (1102a) destiné à former une somme et une différence de la première porteuse cosinus modulée et de la première sinus modulée pour obtenir un premier ensemble de signaux (V1, V2) d'amplitude constante et de phase variable.

4. Système selon la revendication 3, comportant en outre :

   un moyen (1100b) destiné à générer une forme d'onde complémentaire I' (t) à partir de la forme d'onde Q (t) de modulation de porteuse sinus telle que la somme des carrés I' (t) et Q (t) est constante ;
   un moyen (1101d) destiné à moduler un signal de porteuse cosinus avec I' (t) pour obtenir une seconde porteuse cosinus modulée ;
   un moyen (1101c) destiné à moduler un signal de porteuse sinus avec Q (t) pour obtenir une seconde porteuse sinus modulée ;
   un moyen (1102b) destiné à former une somme et une différence de la seconde porteuse cosinus modulée et de la seconde porteuse sinus modulée pour obtenir un second ensemble de signaux (V3, V4) d'amplitude constante et: de phase variable.

FIG. 1

Resultant A(t)

Q axis

I2,Q2

α

γ

I1,Q1

φ(t)

I axis

Difference
Signal
to Waste
Recovery

FIG. 6

Drive
waveform
phase

312

328a

Vcc/2

602

Output current
phase α

N on
P off

332

P

c

Output to
λ/4
line 422

P on
N off

a

b

d

N

604

-Vcc/2

328b

FIG. 2

EP 1 068 666 B1

FIG. 3

FIG. 4

$A(t)\exp(j\,\theta(t))$

332

334

DSP
330

I1

Q1

302

$\Sigma$

306

Vcc 326

Vcc, $I_1 = Vo/Zo1$

PA1

312

Zo1
422

$\lambda/4$

320'

I2

Q2

304

$\Sigma$

308

314

PA2

$\lambda/4$

Zo2
424

440

$Vo = Io \cdot R_L$

Io

$R_L$

326

328

Vcc, $I_2 = Vo/Zo2$

Vcc

400

310

Cos($\omega t$)    Sin($\omega t$)
Quadrature
Oscillator

EP 1 068 666 B1

FIG. 5

FIG. 7

For desired signal of
$A(t)EXP(j \theta (t))$
DSP generates I1, Q1,
I2, Q2, as
$I1, Q1 = EXP(j( \theta (t) + \alpha ))$
$I2, Q2 = EXP(j( \theta (t)- \alpha ))$
where $\alpha = Arccos(A(t)/2)$

$Cos(\omega t)$      $Sin(\omega t)$
Quadrature
Oscillator

$\lambda/4, Zo$

Load
(Antenna)

$R_L$

EP 1 068 666 B1

# FIG. 8

Common
Reference
Frequency
Signal

EP 1 068 666 B1

FIG. 9

Imaginary axis

V1

wanted
real part

I

Real axis

Z

wanted
complex
vector

wanted
imaginary
part

Q

V4

V3

V2

EP 1 068 666 B1

FIG. 10

Four-phasor modulator 1010

I — Desired Real part

Q — Desired imaginary part

Carrier frequency signal

$e^{j(wt+\phi_1)}$  1011a   1012a

$e^{j(wt+\phi_2)}$  1011b   1012b

$e^{j(wt+\phi_3)}$  1011c   1012c

$e^{j(wt+\phi_4)}$  1011d   1012d

Real Part

Imaginary Part

Complex Signal Output

EP 1 068 666 B1

FIG. 11

FIG. 12

4-Phasor Modulator

Data → 1010'

Transmit intermediate frequency signal (TXIF)

Phase Detector 1213a
Local Oscillator Signal Flo
VCO 1215a
1220a

V1 φ — Flo-Ftx =TXIF — 1214a — Ftx — PA 1211a
1216a — Loop Filter

Phase Detector 1213b
Local Oscillator signal Flo
VCO 1215b
1220b

V2 φ — Flo-Ftx =TXIF — 1214b — Ftx — PA 1211b
1216b — Loop Filter

Phase Detector 1213c
Local Oscillator signal Flo
VCO 1215c
1220c

V3 φ — Flo-Ftx =TXIF — 1214c — Ftx — PA 1211c
1216c — Loop Filter

Phase Detector 1213d
Local Oscillator signal Flo
VCO 1215d
1220d

V4 φ — Flo-Ftx =TXIF — 1214d — Ftx — PA 1211d
1216d — Loop Filter

FIG. 13

EP 1 068 666 B1

FIG. 14a

Drain

104

Gate

Substrate

104

102

Source

Collector

FIG. 14b

112

Base

110

Emitter

# FIG. 15

FIG. 16

EP 1 068 666 B1

# FIG. 17

# FIG. 18